# EUROPÄISCHE PATENTSCHRIFT

(11) **EP 2 054 150 B1**
(45) Veröffentlichungstag und Bekanntmachung des Hinweises auf die Patenterteilung: **29.09.2010**
(21) Anmeldenummer: 07785856.1
(22) Anmeldetag: 27.06.2007
(51) Int. Cl.: B01J 20/28, B01J 20/18, B01J 20/22, B01J 20/32, B01D 53/26, B01D 53/28, H01L 23/26, C01B 39/00, B01J 20/06, C01B 39/14, C01B 39/54

(54) **HYDROPHOB BESCHICHTETES MOLEKULARSIEB**
HYDROPHOBICALLY COATED MOLECULAR SIEVE
TAMIS MOLÉCULAIRE À REVÊTEMENT HYDROPHOBE

(30) Priorität: 27.06.2006 DE 102006029849
(43) Veröffentlichungstag der Anmeldung: 06.05.2009
(73) Patentinhaber: Nanoscape AG, 82152 Planegg (DE); SAES GETTERS S.p.A., 20020 Lainate (Milano) (IT)
(72) Erfinder: SAUER, Jürgen, 82152 Planegg (DE); KOHL, A., 82152 Planegg (DE)
(74) Vertreter: Forstmeyer, Dietmar
(86) Internationale Anmeldenummer: PCT/EP2007/005679
(87) Internationale Veröffentlichungsnummer: WO 2008/000457

(56) Entgegenhaltungen:
- EP-A- 1 020 403
- EP-A- 1 262 455
- EP-A- 1 652 581
- WO-A-2005/002722
- WO-A-2005/049170
- DE-A1- 3 511 323
- DE-A1- 10 056 362
- DE-A1- 10 319 937
- DE-A1- 10 344 449
- DE-A1- 10 344 819
- DE-A1- 19 530 031
- DE-A1- 19 614 136
- US-A1- 2005 084 438
- US-A1- 2005 154 222
- US-A1- 2006 054 559
- US-A1- 2006 093 795
- YANGYANG SUN ET AL: "Study and characterization on the nanocomposite underfill for flip chip applications" ELECTRONIC COMPONENTS AND TECHNOLOGY, 2004. ECTC '04. PROCEEDINGS LAS VEGAS, NV, USA JUNE 1-4, 2004, PISCATAWAY, NJ, USA,IEEE, Bd. 1, 1. Juni 2004 (2004-06-01), Seiten 477-483, XP010714713 ISBN: 978-0-7803-8365-4
- DATABASE INSPEC [Online] THE INSTITUTION OF ELECTRICAL ENGINEERS, STEVENAGE, GB; Februar 2006 (2006-02), LIU RUI-JUN ET AL: "Modification of di-ethoxy-silicane moisture-resistant films for neodymium-doped phosphate glass" XP002497411 Database accession no. 8896293 -& High Power Laser and Particle Beams Nucl. Soc. China China, Bd. 18, Nr. 2, Februar 2006 (2006-02), Seiten 215-218, XP009105931 ISSN: 1001-4322
- "COLLOIDAL SILICA ED - ELVERS B; HAWKINS S; RUSSEY W; SCHULZ G" REFRACTORY CERAMICS TO SILICON CARBIDE; [ULLMANN'S ENCYCLOPEDIA OF INDUSTRIAL CHEMISTRY], WEINHEIM, VCH, DE, Bd. VOL. A23, 1. Januar 1993 (1993-01-01), Seiten 614-620, XP001028478
- VALENTIN ET AL: "Characterization of the reactivity of a silica derived from acid activation of sepiolite with silane by <29>Si and <13>C solid-state NMR" JOURNAL OF COLLOID AND INTERFACE SCIENCE, ACADEMIC PRESS, NEW YORK, NY, US, Bd. 298, Nr. 2, 15. Juni 2006 (2006-06-15), Seiten 794-804, XP005416616 ISSN: 0021-9797
- SUZUKI N ET AL: "Effects of rubber/filler interactions on deformation behavior of silica filled SBR systems" POLYMER, ELSEVIER SCIENCE PUBLISHERS B.V, GB, Bd. 46, Nr. 1, 6. Januar 2005 (2005-01-06), Seiten 193-201, XP004678198 ISSN: 0032-3861
- PERRUCHOT C ET AL: "XPS characterisation of core-shell silica-polymer composite particles synthesised by atom transfer radical polymerisation in aqueous media" EUROPEAN POLYMER JOURNAL, PERGAMON PRESS LTD. OXFORD, GB, Bd. 40, Nr. 9, 1. September 2004 (2004-09-01), Seiten 2129-2141, XP004523632 ISSN: 0014-3057
- VON WERNE T ET AL: "Preparation of Structurally Well-Defined Polymer-Nanoparticle Hybrids with Controlled/Living Radical Polymerizations" JOURNAL OF THE AMERICAN CHEMICAL SOCIETY, Bd. 121, Nr. 32, 1999, Seiten 7409-7410, XP002497409 -& VON WERNE T ET AL: "Supporting Information: Preparation of Structurally Well-Defined Polymer-Nanoparticle Hybrids with Controlled/Living Radical Polymerizations" JOURNAL OF THE AMERICAN CHEMICAL SOCIETY, [Online] Bd. 121, Nr. 32, 1999, Seiten S1-S10, XP002497410 Gefunden im Internet: URL:http://pubs.acs.org/subscribe/journals /jacsat/suppinfo/121/i32/ja991108l/ja99110 8l_s.pdf> [gefunden am 2008-09-19]

## Beschreibung

Die vorliegende Erfindung betrifft ein beschichtetes Molekularsieb und ein Verfahren zu dessen Herstellung. Außerdem betrifft die Erfindung die Verwendung des beschichteten Molekularsiebs sowie auf Zusammensetzungen, die das Molekularsieb enthalten. Weiterhin betrifft die vorliegende Erfindung die Verwendung des Molekularsiebs bzw. von Zusammensetzungen, die das Molekularsieb enthalten, bei der Herstellung von Vorrichtungen, wie beispielsweise elektronischen Bauteilen und Geräten, sowie Vorrichtungen, wie beispielsweise elektronische Bauteile und Geräte, die das Molekularsieb enthalten. Insbesondere betrifft die vorliegende Erfindung ein hydrophob beschichtetes Molekularsieb und ein Verfahren zu dessen Herstellung. Außerdem betrifft die Erfindung die Verwendung des hydrophob beschichteten Molekularsiebs sowie auf Zusammensetzungen, die das hydrophob beschichtete Molekularsieb enthalten. Weiterhin betrifft die vorliegende Erfindung die Verwendung des hydrophob beschichteten Molekularsiebs bzw. von Zusammensetzungen, die das hydrophob beschichtete Molekularsieb enthalten, bei der Herstellung von Vorrichtungen, wie beispielsweise elektronischen Bauteilen und Geräten, sowie Vorrichtungen, wie beispielsweise elektronische Bauteile und Geräte, die das Molekularsieb enthalten.

### Hintergrund der Erfindung

Moderne elektrische und elektronische Bauteile und Geräte umfassen häufig Materialien oder Stoffe, die gegenüber gasförmigen Molekülen aus der Umgebungsatmosphäre, wie z.B. Sauerstoff oder Wasserdampf, empfindlich sind, weil sie durch die Einwirkung dieser Moleküle angegriffen werden und z.B. durch Korrosion oder Hydrolyse zerstört werden können. Ein übliches Verfahren zum Schutz derartige Materialien in Bauteilen und Geräten stellt eine Verkapselung dar, bei der die Bauteile oder Geräte hermetisch gegenüber der Umgebung abgeschlossen werden. Dabei ist es auch üblich, so genannte "Getter" in den Innenraum der gekapselten Bauteile oder Geräte einzubringen, die dazu geeignet sind, trotzdem eindringende Gasmoleküle abzufangen.

Übliche Gettermaterialien sind Substanzen, welche kleine Moleküle, wie z.B. Gasmoleküle oder Wasser, durch eine chemische Reaktion binden ("Absorbieren") oder physikalisch aufnehmen ("Adsorbieren") können. Gängig verwendete Gettermaterialien sind Metalle oder Metalllegierungen oder Molekularsiebe. Derartige Gettermaterialien, die eingesetzt werden, um Materialien oder Bauteile vor dem schädlichen Einfluss von Feuchtigkeit (Wasser) oder von Gasen, wie z.B. Sauerstoff, zu schützen, sind u.a. in DE 3218625 A1, DE 3511323 A1, oder DE 3101128 A1 beschrieben.

Neben dem Einbringen eines Gettermaterials in den Innenraum eines gekapselten Bauteils oder Geräts, ist es auch möglich, Gettermaterialien in organische Materialien einzubringen, die dazu verwendet werden, die empfindlichen Materialien in den Bauteilen oder Geräten bzw. die Bauteile oder Geräte selbst zu versiegeln. Beispielsweise können die Gettermaterialien in organische Polymere, Klebstoffe oder Lacke eingebracht werden, welche dann dazu verwendet werden, ein Bauteil oder ein Gerät einzugießen, ein Gehäuse davon zu verkleben, oder mit einer Beschichtung zu überziehen. Eine KlebstoffZusammensetzung mit Barriere-Eigenschaften wird in DE 10344449 A1 offenbart, und DE 19853971 A1 beschreibt anorganisch/organische Polysiloxanhybridpolymere. Weiterhin offenbart US 2004/0132893 A1 eine formbare Paste aus einem Zeolith, einem organischen Bindemittel und einem Lösungsmittel, die zur Herstellung eines Getters verwendet wird. Das US-Patent Nr. 5,401,536 beschreibt ein Beschichtungsmittel und einen Klebstoff zur Herstellung einer feuchtigkeitsfreien Versiegelung einer elektronischen Vorrichtung, welche aus einem protonierten Alumosilicatpulver und einem Polymer bestehen. Alle diese Zusammensetzungen umfassen Gettermaterialien, die mehr oder weniger grob in einer Matrix eingebettet, aber nicht homogen dispergiert sind (Pasten). Mit keiner dieser Zusammensetzungen lassen sich transparente Schichten herstellen, und sie können auch nicht in einem Druckverfahren verwendet werden.

In den letzten Jahren ist ein verstärkter Trend zur Miniaturisierung von vielen elektrischen und elektronischen Geräten zu beobachten. Diese fortschreitende Miniaturisierung wirft viele Probleme auf, nicht zuletzt bezüglich des Schutzes von empfindlichen Materialien, Bauteilen oder Geräten vor Feuchtigkeit oder anderen schädlichen Gasmolekülen aus der Umgebungsatmosphäre. Einerseits werden die zu schützenden Mengen der empfindlichen Materialien immer geringer, so dass schon eine geringere Anzahl von Gasmolekülen ausreicht, um sie zu schädigen. Daher muss der Schutz so gut werden, dass möglichst kein einziges schädliches Gasmolekül das empfindliche Material erreicht. Andererseits wird auch der zur Verfügung stehende Platz innerhalb eines gekapselten Bauteils oder Geräts immer geringer, so dass ein Getter möglichst in kleiner Form vorliegen sollte, um in einer derartig dimensionierten Vorrichtung verwendet zu werden. Auch wenn ein Getter in eine Versiegelungs- oder Abdeckschicht zum Versiegeln eines derartig dimensionierten Bauteils oder Geräts eingebracht werde soll, sollte der Getter in möglichst kleiner Form vorliegen. Denn es sinken nicht nur die Dicke einer ein Bauteil oder Material schützenden Schicht, sondern auch die Abmessung in der Fläche (Breite und Tiefe) und begrenzen die mögliche Partikelgröße eines Gettermaterials, so dass der Einsatz von herkömmlichen Gettermaterialien mit einer Partikelgröße im Bereich von einigen Mikrometern nachteilig oder unmöglich sein kann. Gerade im Zuge der aktuell schnell fortschreitenden Miniaturisierung von elektronischen Bauteilen, wie z.B. MEMS-Devices, und von immer geringeren Abmessungen von, z.B. elektro-optischen Geräten, die diese enthalten, ist der Einsatz herkömmlicher Gettermaterialien deshalb nur noch begrenzt möglich, da diese in Partikeln mit einer Teilchengröße von meist einigen Mikrometern vorliegen.

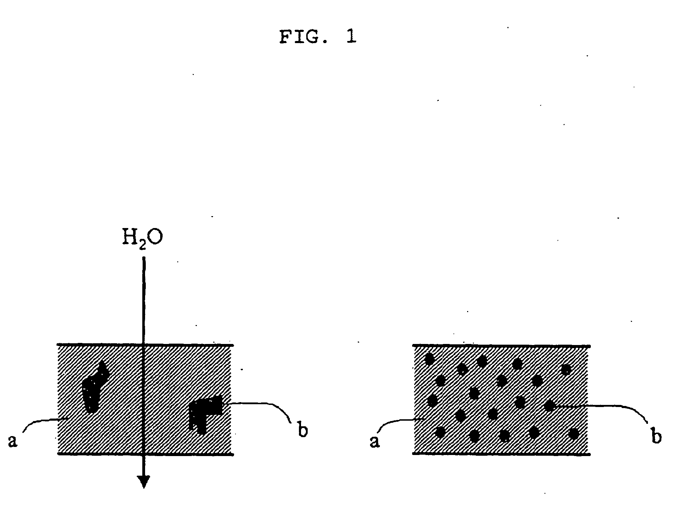

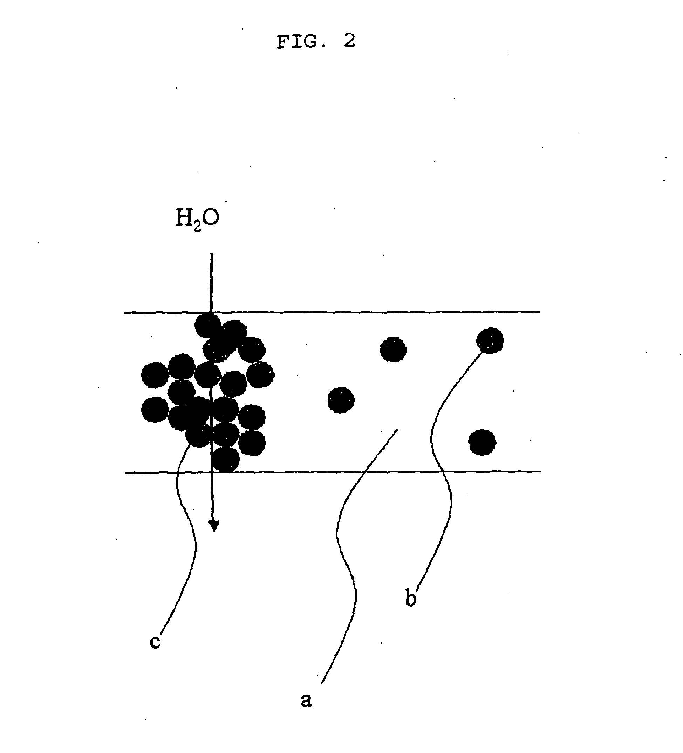

Wenn Kompositmaterialien, umfassend ein Polymer, einen Lack oder einen Klebstoff und ein Gettermaterial, zur Verkapselung von empfindlichen Materialien, Stoffen, Bauteilen oder Geräten verwendet werden sollen, kann ein Gettermaterial das Material, das Bauteil oder das Gerät dann besonders effektiv schützen, wenn die einzelnen Partikel klein gegenüber der Dicke der aus dem Kompositmaterial bestehenden Schicht sind, und wenn diese homogen verteilt sind. Sind die Partikel zu groß gegenüber der Dicke der Kompositschicht, kann es zu Gas- oder Wasserdurchbrüchen an Stellen kommen, an denen auf Grund der statistischen Verteilung der Getterpartikel in der Schicht kein Partikel vorliegt, wie in Figur 1 gezeigt. Andererseits kann es auch an Stellen zu Gas- oder Wasserdurchbrüchen kommen, an denen Anhäufungen oder Agglomerationen von Getterteilchen auftreten, wie in Figur 2 gezeigt. Deshalb sollte ein Gettermaterial gut in den organischen Verbindungen dispergierbar sein, mit denen es gemeinsam in den Kompositmaterial vorliegt. Die schlechte Dispergierbarkeit in vielen organischen Verbindungen, die üblicherweise zur Versiegelungszwecken verwendet werden, wie z.B. Polymere, Klebstoffe, Lacke, oder dergleichen, ist ein weiterer Nachteil herkömmlicher Gettermaterialien.

Beispielsweise sind herkömmliche Gettermaterialien, wie z.B. Zeolithe, in apolaren Medien, wie es viele Polymere, Klebstoffe, Lacke, Lösungsmittel und dergleichen sind, nur schlecht dispergierbar. Generell können oxidische Materialien, zu denen auch die Zeolithe gehören, schlecht in apolaren Lösemitteln dispergiert werden, gut dagegen in Wasser, wässrigen Säuren und Basen. Der Grund für dieses Verhalten liegt in der Oberflächenchemie dieser Materialklasse begründet. Die äußere Oberfläche oxidischer Materialien, zu denen auch die Zeolithe gehören, ist meist mit OH-Gruppen terminiert [Nature and Estimation of Functional Groups on Solid Surfaces, H.P. Boehm, H. Knözinger, Catalysis Science and Technology, Vol. 4, Springer Verlag, Heidelberg, 1983]. Dispergiert man ein Oxid in Wasser kommt es zu vielfältigen Wechselwirkungen dieser OH-Gruppen mit Wasser. Es können sich Wasserstoffbrückenbindungen ausbilden, welche zu einer anhaftenden Wasserschicht auf dem Oxid führen. Die Existenz einer solchen, anhaftenden Wasserschicht auf dem Oxid kann dazu führen, dass das Oxid als stabile wässerige Suspension erhalten werden kann, weil sich die Oxidpartikel nicht berühren können und somit auch nicht agglomerieren können. Abhängig vom pH-Wert einer Lösung kann ein Zeolith Protonen verlieren oder aufnehmen, indem ein Teil der an der Oberfläche liegenden OH-Gruppen ein Proton verliert oder aufnimmt. Die entsprechende OH-Gruppe liegt dann als O⁻ Zentrum oder als OH₂⁺ Gruppe vor. Zusätzliche Ladungen auf dem Oxid führen zu einer weiteren Stabilisierung einer wässerigen Suspension, weil sich nähernde Partikel Abstoßungskräfte erfahren, und sich deshalb nicht berühren können und nicht agglomerieren bzw. verklumpen können.

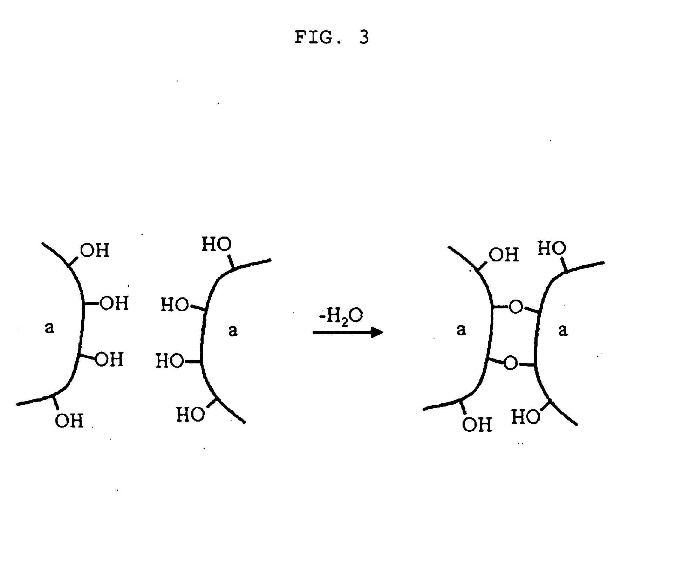

In apolarer Umgebung jedoch, wie beispielsweise in organischen Lösungsmitteln, wie z.B. Hexan, Toluol oder Petrolether, oder flüssigen, aufgeschmolzenen Polymeren niedriger Polarität, wie z.B. Polyethylen, kann es nicht zur Ausbildung der genannten Wechselwirkungen zwischen der Oxidoberfläche und dem Lösemittel kommen, weil die Lösungsmittelmoleküle keine Wasserstoffbrückenbindungen ausbilden können. Zudem werden Ladungen durch die Moleküle niedriger Polarität nicht stabilisiert. Das bedeutet, dass die Oberfläche von Oxiden in apolaren Lösemitteln nur geringfügigst geladen ist. Abstoßungskräfte zwischen den Oxidpartikeln sind also nicht oder in nur geringem Maß vorhanden. Oxidische Stoffe bilden deshalb in apolaren Lösemitteln Agglomerate und klumpen zusammen, wie in Figur 3 gezeigt. Hierbei tritt häufig eine Kondensationsreaktion der an der Oberfläche vorhandenen OH-Gruppen auf, so dass die Partikel irreversibel miteinander verwachsen und so grosse Agglomerate bilden. Diese Agglomerate können nicht mehr dispergiert werden.

Um oxidische Partikel in apolaren Lösemitteln dispergieren zu können, können die an der Oberfläche des jeweiligen Oxids befindlichen OH-Gruppen mit organischen Gruppen funktionalisiert werden, welche dem jeweiligen Lösemittel möglichst ähnlich sind Derartige Oberflächenbeschichtungen werden beispielsweise in DE 10319 937 A1 beschrieben.

Die Oberfläche der Oxidpartikel kann so mit apolaren und kovalent angebundenen Gruppen beschichtet werden. Die Ausbildung einer kovalenten, chemisch beständigen Bindung ist wünschenswert, weil ein Verlust der apolaren Gruppen zu einer verstärkten Agglomerationsneigung der Partikel führen kann. Der Ausbildung einer dauerhaften kovalenten Bindung wird der Vorzug gegenüber ionischen Bindungen gegeben, wie sie z.B. in "The surface modification of zeolite-4A by CTMAB and its properties", L. Guo, Y. Chen, J. Yang, Journal of Wuhan Unisversity of Technology, Materials Science and Engineering, Wuhan University of Technology, Materials Science Edition (1999), 14(4), 18-23, beschrieben sind, da ionische Bindungen, welche auf der Bildung von Ionenpaaren beruhen, leicht durch andere Ionen aufgebrochen werden können.

Zwischen den reaktionsträgen organischen Gruppen auf der Oberfläche eines so beschichteten Partikels können keine Kondensationsreaktionen stattfinden. Wechselwirkungen zwischen Partikeln beruhen deswegen hauptsächlich auf Vander-Waals Kräften. D.h. falls sich zwei Partikel berühren, können diese nicht dauerhaft und irreversibel agglomerieren. In apolaren Lösemitteln lassen sich derart funktionalisierte Oxide gut dispergieren.

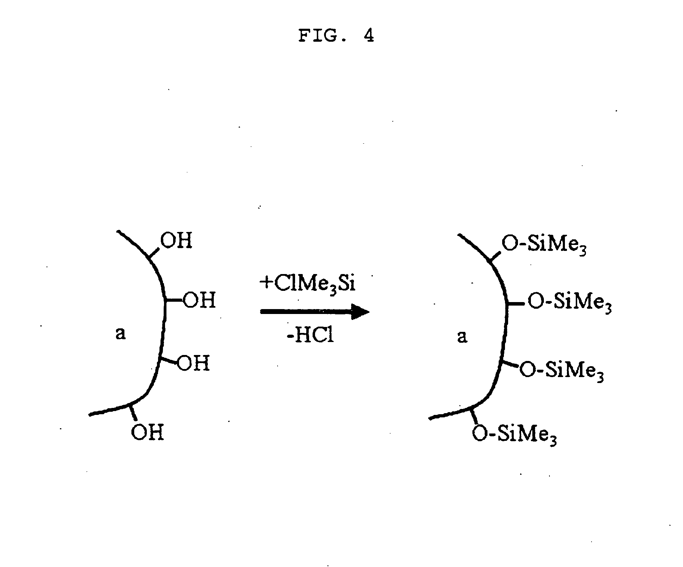

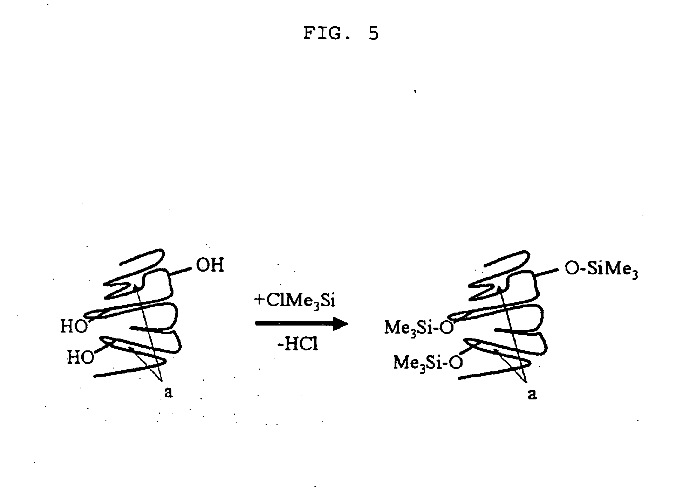

Gängige Reagenzien zur Funktionalisierung sind Chlorsilane, wie z.B. Trimethylchlorsilan (TMSC1) oder auch Diethyldichlorsilan. Mit Alkylhalogensilanen oberflächenmodifizierte Zeolithpulver werden bespielsweise in EP 1 020 403 A1 beschrieben. Bei Umsetzen eines Oxids mit einem derartigen Reagenz wird Chlorwasserstoff abgespalten und es bildet sich eine kovalente Bindung zwischen dem Silanrest und der Oberfläche des Oxids aus, wie in Figur 4 gezeigt. Allerdings haben diese Reagenzien den Nachteil, dass das Gettermaterial durch die aggresiven Chlorwasserstoffmoleküle angegriffen werden kann. Untersuchungen der Erfinder der vorliegenden Erfindung haben gezeigt, dass gerade Alkylhalogensilane die Struktur von Zeolithteilchen zerstören, wobei dieser Effekt umso ausgeprägter ist, je kleiner die Teilchen sind, da bei diesen die relative äußere Oberfläche stärker zunimmt. Allgemein leiden poröse Partikel besonders unter dieser Zerstörung, weil sie wahrscheinlich nicht nur von Außen, sondern gleichzeitig auch von Innen von den aggresiven Halogenverbindungen angegriffen werden. Nachteilig bei der Verwendung von Halogensilan-Reagenzien ist auch, dass es bei der Beschichtung von porösen Partikeln zu einer Beschichtung und/oder Blockierung bzw. Verstopfung der Poren, inneren Kanäle und Kavitäten der Partikel kommen kann. Wünschenswert sind Systeme, bei denen die innere Oberfläche weder beschichtet noch blockiert wird, und so ihren ursprünglichen Charakter behält, wie in Figur 5 gezeigt.

Deshalb werden oxidische Gettermaterialien, wie z.B. Zeolithe, auch mit Alkoxysilanen umgesetzt, um die äußere Oberfläche zu silanisieren, wie in "Surface organometallic chemistry on zeolites: a tool for modifying the sorption properties of zeolites" A. Choplin, Journal of Molecular Catalysis (1994), 86(1-3), 501-512 beschrieben. Allerdings werden dort so modifizierte Zeolithe ausschließlich als eine Zwischenstufe für eine weitere Modifizierung beschrieben. Dies ist insbesondere möglich, weil derartig modifizierte Zeolithe ähnliche Oberflächeneigenschaften besitzen, wie nicht modifizierte Zeolithe, wie sie oben beschrieben sind. Insbesondere werden dabei Silankopplungsmittel verwendet, die in wässerigen Medien miteinander vernetzen können. Dieser Effekt wird beispielsweise bei den mit den Silankopplungsmitteln Aminopropyltrimethoxysilan oder Glycidyloxypropyltrimethoxysilan beschichteten Zeolithteilchen, die in DE 100 56 362 A1 beschrieben werden, ausgenutzt, um eine kolloidale wässerige Suspension von Zeolithteilchen zu stabilisieren. Ein Verfahren zur Herstellung von derartig oberflächenmodifiziertem Zeolith sowie dessen Anwendung in Wasch- und Reinigungsmitteln wird in EP 0 088 158 A1 beschrieben. Diese oberflächenmodifizierten Zeolithe sind entsprechend ihrer Anwendung hydrophile Teilchen, die entsprechend nicht homogen in lipophilen organischen Verbindungen, wie z.B. Alkanen, dispergiert werden können.

Herkömmliche Zeolithe besitzen meist eine Partikelgröße von einigen Mikrometern (s. z.B. die Informationsbroschüre "Dessipaste^{™}" der Firma Südchemie AG). Diese können beschichtet werden, wie z.B. beschrieben in "Silylation of micro-, meso-, and non-porous oxides: a review"; N. Impens; P. Van der Voort; E. Vansant; Microporous and Mesoporous Materials (1999), 28(2), 217, oder in "Chemical modifications of oxide surfaces"; P.Cool; E. Vansant; Trends in physical Chemistry (1999), 7, 145-158. Diese Quellen beschreiben jedoch keine Dispersionseigenschaften dieser beschichteten Zeolithpartikel in Polymeren oder allgemeiner in apolaren Medien. Auch wird ein Einsatz von beschichteten Zeolithen als Gettermaterial in dünnen Schichten nicht beschrieben.

Ein weiterer Nachteil bei Einsatz von herkömmlichen Gettermaterialien in Polymeren ist die mögliche Trübung des Polymers durch Streuprozesse, die durch Getterpartikeln mit einem gegenüber dem Polymer abweichenden Brechungsindex und einer mittleren Größe weit oberhalb der Grenze der Mie-Streuung von etwa 40 nm für sichtbares Licht hervorgerufen werden. Sollen transparente Schichten erzeugt werden, wie sie z.B. für das Einkapseln von Solarzellen oder OLEDs benötigt werden, muss eine solche Trübung vermieden werden, bzw. sollte so gering wie möglich sein.

Ein weiterer Nachteil herkömmlicher Getter ist es, dass sie aufgrund ihrer Größe nicht mit üblichen Verfahren zur Herstellung von miniaturisierten elektronischen Bauteilen und Geräten verträglich sind. Derartige Vorrichtungen werden heutzutage meist maschinell unter Verwendung von automatischen Vorrichtungen, wie z.B. Druck- oder Sprayvorrichtungen, auf geeignete Oberflächen aufgedruckt. Die dabei verwendeten Druckdüsen haben einen Innendurchmesser im Bereich von einigen Mikrometern. Deshalb dürfen in zu verarbeitenden Getter-haltigen Flüssigkeiten nicht nur keine Partikel mit einer Größe größer als der Innendurchmesser der Düse vorhanden sein, sondern auch keine Agglomerate von Feststoffen, welche die Düse verstopfen könnten.

### Kurze Beschreibung der Erfindung

Es war die Aufgabe der nachstehend beschriebenen Erfindung, die genannten Nachteile üblicher Materialien zu überwinden.

Insbesondere soll die Erfindung ein Molekularsieb bereitstellen, dass klein genug ist, um in miniaturisierten Vorrichtungen eingesetzt zu werden, wobei es auch dazu geeignet sein soll, um in organischen Verbindungen, insbesondere in apolaren organischen Verbindungen homogen dispergiert zu werden. Das Molekularsieb soll auch dazu geeignet sein, transparente Schichten herzustellen. Darüber hinaus soll das Molekularsieb zur Verarbeitung in einem Druckverfahren geeignet sein.

Nach intensiven Studien haben die Erfinder der vorliegenden Erfindung gefunden, dass die Aufgabe der Erfindung gelöst wird durch ein Molekularsieb, wie in Anspruch 1 definiert.

### Beschreibung der Figuren

Figur 1 zeigt schematisch den Aufbau zweier Schichtsysteme, umfassend (a) ein organisches Polymer und (b) Getterpartikel.
Figur 2 zeigt schematisch eine Schicht aus a) Polymer, b) Getterpartikeln, welche einen Cluster (c) bilden. Der eingezeichnete Pfeil kennzeichnet den schnellsten Weg für eindiffundierendes Wasser.
Figur 3 zeigt schematisch das Verklumpen von oxidischen Partikeln mit Oberflächen-OH-Gruppen. Mit a) ist das Innere eines oxidischen Partikels gekennzeichnet.
Figur 4 zeigt schematisch die Hydrophobisierung von oxidischen Partikeln mit Oberflächen-OH-Gruppen. Mit a) ist das Innere eines oxidischen Partikels gekennzeichnet.
Figur 5 zeigt schematisch die Hydrophobisierung von oxidischen Partikeln mit Porenstruktur. Mit a) ist das Innere eines oxidischen Partikels gekennzeichnet.
Figur 6 zeigt schematisch einen Mehrschichtenaufbau, welcher aus alternierenden Barriereschichten (a) und Polymer/Molekularsieb-Komposit (b) besteht.
Figur 7 zeigt eine typische Größenverteilung der in den Beispielen eingesetzten Partikel aus Zeolith LTA. Es ist die Masseverteilung gegen den Partikeldurchmesser in nm aufgetragen.
Figur 8 zeigt schematisch den Aufbau eines Wasserpermeationstests. Dabei bezeichnet a) ein mit wasserfreiem blauen Cobaltchlorid getränktes Papier, b) eine Polymerschicht, und c) Wasser.
Figur 9 zeigt fotographische Aufnahmen, die die Ergebnisse einer Untersuchung zur Barriereeigenschaft eines Kompositmaterials mit Cobaltchlorid festhalten (Wasserpermeationstest). Wasserfreies blaues Cobaltchlorid erscheint in den Fotos dunkelgrau, wasserhaltiges rosa Cobaltchlorid hellgrau. Die obere Reihe zeigt eine Referenzprobe, die untere Reihe eine Probe gemäß der Erfindung, jeweils zu Beginn des Versuchs (3 Minuten), und nach 28 bzw. 100 Minuten.
Figur 10 zeigt das Ergebnis einer Untersuchung der Eigenschaften von Lacken, die das erfindungsgemäße Molekularsieb umfassen, durch einen Calciumspiegeltest.

### Detaillierte Beschreibung der Erfindung

Die Erfindung betrifft ein hydrophob beschichtetes Molekularsieb mit Partikeln einer Partikelgröße von 1000 nm oder weniger, wobei die Oberfläche der Partikel mit einem Silan der allgemeinen Formel

SiR¹R²R³R⁴

beschichtet wird, wobei zwei, oder drei der Reste R¹, R², R³ oder R⁴ des Silans unabhängig voneinander ein hydrolysierbarer Alkoxyrest ist bzw. sind, und wobei die restlichen Reste R¹, R², R³ und R⁴ unabhängig voneinander ausgewählt werden aus nicht-hydrolysierbaren unsubstituierten Alkylresten, Alkenylresten, Alkinylresten, Cycloalkylresten, Alkylcycloalkylresten, Arylresten, und Arylalkylresten, wobei die Partikel anorganische Partikel umfassen, die ausgewählt werden aus Partikeln, die poröse Alumophosphate, poröse Silicoalumophosphate oder Zeolithe umfassen, und wobei in jedem der oben aufgeführten Reste jeweils ein oder mehrere Wasserstoffatome durch Halogenatome ersetzt werden können.

In einer bevorzugten Ausführungsform umfasst mindestens einer der Reste R¹, R², R³ oder R⁴ eine hydrolysierbare Gruppe, die ausgewählt wird aus einer Alkoxygruppe und einer Cyanidgruppe.

Dabei steht der Ausdruck Molekularsieb insbesondere für eine Verbindung, die kleine Moleküle binden kann. Der Ausdruck kleine Moleküle bezieht sich dabei z.B. auf Moleküle aus zwei bis zwölf Atomen, vorzugsweise aus zwei bis sechs Atomen, und besonders bevorzugt zwei bis drei Atomen. Diese Moleküle können bei Normalbedingungen als ein Gas vorliegen, das beispielsweise in der Umgebungsatmosphäre anzutreffen sein kann. Bevorzugte Beispiele für derartige Moleküle sind in Luft enthaltene Gase wie z.B. Sauerstoff (O₂) oder auch Wasser (H₂O). Die Bindung der Moleküle durch das Molekularsieb ist im allgemeinen reversibel oder irreversibel, und ist bevorzugt reversibel. Bevorzugt sind die Molekularsiebe poröse Verbindungen, die kleine Moleküle nicht nur auf ihrer Oberfläche, sondern auch im Inneren ihrer Poren binden können.

Der Ausdruck Partikel bedeutet individuelle Partikel oder Teilchen aus Molekularsieb, die vorzugsweise in Form diskreter Partikel vorliegen. Die Partikel können in Form eines Einkristalls vorliegen oder ihrerseits agglomerierte kleinere, kristalline oder nicht-kristalline Partikel umfassen, welche fest miteinander verbunden sind. Beispielsweise können die einzelnen Partikel in Form einer Mosaikverbindung vorliegen, die aus kleineren Einkristalliten besteht. Die Partikel können in runder Form, wie beispielsweise kugelförmig, eiförmig oder in Form eines Ellipsoids oder dergleichen, oder kantiger Form, wie beispielsweise in Form von Würfeln, Quadern, Plättchen oder dergleichen, vorliegen. Vorzugsweise sind die Partikel kugelförmig.

Der Ausdruck Partikelgröße bedeutet hier den maximalen Durchmesser eines Partikels. Hier wird der Ausdruck für den maximalen Durchmesser eines unbeschichteten Partikels verwendet. Die Partikelgröße eines Partikels wird beispielsweise durch übliche Verfahren unter Verwendung des Prinzips der dynamischen Lichtstreuung bestimmt. Dazu werden die Partikel in einem geeigneten inerten Lösungsmittel suspendiert bzw. dispergiert und mit einem geeigneten Messgerät gemessen. Die Größe der Partikel kann auch durch Messung unter Verwendung von REM-(Raster-Elektronen-Mikroskop)-Aufnahmen bestimmt werden. Die einzelnen Partikel sind bevorzugt kugelförmig. Die Partikelgröße der Partikel beträgt 1000 nm oder weniger, vorzugsweise 800 nm oder weniger, weiter bevorzugt 600 nm oder weniger, noch weiter bevorzugt 400 nm oder weniger, noch weiter bevorzugt 300 nm oder weniger, noch weiter bevorzugt 200 nm oder weniger, noch weiter bevorzugt 100 nm oder weniger, noch weiter bevorzugt 40 nm oder weniger, und besonders bevorzugt 26,6 nm oder weniger. Die minimale Partikelgröße beträgt 2 nm oder mehr, vorzugsweise 5 nm oder mehr, weiter bevorzugt 10 nm oder mehr, und besonders bevorzugt 15 nm oder mehr.

Der Ausdruck Hydroxidrest steht für die Gruppe -OH.

Der Ausdruck Alkylrest bedeutet eine gesättigte, geradkettige oder verzweigte Kohlenwasserstoffgruppe, die insbesondere 1 bis 20 Kohlenstoffatome, vorzugsweise 1 bis 12 Kohlenstoffatome, weiter bevorzugt 1 bis 8, und besonders bevorzugt 1 bis 6 Kohlenstoffatome aufweist, wie beispielsweise die Methyl-, Ethyl-, Propyl-, Isopropyl-, n-Butyl-, Isobutyl-, sec-Butyl-, tert-Butyl, n-Pentyl, Isopentyl-, neo-Pentyl-, sec-Pentyl-, tert-Pentyl-, n-Hexyl-, 2,2-Dimethylbutyl- oder n-Octyl-Gruppe. Noch stärker bevorzugt ist der Alkylrest eine verzweigte Kohlenstoffgruppe mit 3 bis 8 Kohlenstoffatomen, besonders bevorzugt mit 3 bis 6 Kohlenstoffatomen, wie beispielsweise eine Isopropyl-, Isobutyl-, sec-Butyl-, tert-Butyl, Isopentyl-, neo-Pentyl-, sec-Pentyl-, tert-Pentyl-, oder 2,2-Dimethylbutyl-Gruppe. Die Verwendung von Silanen mit verzweigten Alkylresten resultiert vorteilhaft in einer hohen Hydrophobizität des erfindungsgemäßen Molekularsiebes. Dies wird vermutlich durch eine gute Abschirmung der hydrophilen Molekularsieboberfläche gegenüber einem Lösungsmittel verursacht. Ein Alkylrest im Sinne der Erfindung ist durch eine Silicium-Kohlenstoff-Bindung an das zentrale Siliciumatom des Silans gebunden und ist nicht hydrolysierbar.

Die Ausdrücke Alkenylrest und Alkinylrest beziehen sich auf zumindest teilweise ungesättigte, geradkettige oder verzweigte Kohlenwasserstoffgruppen, die insbesondere 2 bis 20 Kohlenstoffatome, vorzugsweise 2 bis 12 Kohlenstoffatome, und besonders bevorzugt 2 bis 6 Kohlenstoffatome aufweisen, wie beispielsweise die Vinyl- bzw. Ethenyl-, Allyl-, Acetylenyl-, Propargyl-, Isoprenyl- oder Hex-2-enyl-Gruppe. Bevorzugt weisen Alkenylgruppen eine oder zwei (besonders bevorzugt eine) Doppelbindungen bzw. Alkinylgruppen eine oder zwei (besonders bevorzugt eine) Dreifachbindungen auf. Ein Alkenyl- bzw. Alkinylrest im Sinne der Erfindung ist durch eine Silicium-Kohlenstoff-Bindung an das zentrale Siliciumatom des Silans gebunden und ist nicht hydrolysierbar.

Des weiteren beziehen sich die Ausdrücke Alkylrest, Alkenylrest und Alkinylrest auf Gruppen, bei denen z.B. ein oder mehrere Wasserstoffatom(e) durch jeweils ein Halogenatom (Fluor, Chlor, Brom, oder Iod) ersetzt ist bzw. sind, wie beispielsweise die Chlormethyl-, Brommethyl-, Trifluormethyl-, 2-Chlorethyl-, 2-Bromethyl-, 2,2,2-Trichlorethyl-, oder die Heptadecafluoro-1,1,2,2-tetrahydrodecylgruppe.

Bevorzugte Beispiele für hydrolysierbare Alkoxygruppen sind. Methoxy, Trifluormethoxy, Ethoxy, n-Propyloxy, iso-Propyloxy, und tert-Butyloxy.

Der Ausdruck Cycloalkylrest bezieht sich auf eine gesättigte cyclische Gruppe, die einen oder mehrere Ringe (bevorzugt 1, 2 oder 3) aufweist, die ein Gerüst bilden, welches insbesondere 3 bis 14 Kohlenstoffatome, vorzugsweise 3 bis 10 (insbesondere 3, 4, 5, 6 oder 7) Kohlenstoffatome enthält. Der Ausdruck Cycloalkyl bezieht sich weiterhin auf Gruppen, bei denen ein oder mehrere Wasserstoffatome unabhängig voneinander durch jeweils ein Fluor-, Chlor-, Brom- oder Jodatom ersetzt sind. Ein erfindungsgemäßer Cycloalkylrest ist durch eine Silicium-Kohlenstoff-Bindung an das zentrale Siliciumatom des Silans gebunden und ist nicht hydrolysierbar. Bevorzugte Beispiele für nicht hydrolysierbare Cycloalkylgruppen sind die Cyclopropyl-, Cyclobutyl-, Cyclopentyl-, Spiro[4,5]decanyl-, Norbornyl-, Cyclohexyl-, Decalinyl-, Cubanyl-, Bicyclo[4.3.0]nonyl-, Tetralin-, Cyclopentylcyclohexyl-, Fluorcyclohexyl-, oder die Adamantyl-Gruppe.

Der Ausdruck Alkylcycloalkylrest bezieht sich auf Gruppen, die entsprechend den obigen Definitionen sowohl Cycloalkylwie auch Alkyl gruppen enthalten. Bevorzugt enthält eine Alkylcycloalkylgruppe eine Cycloalkylgruppe, die einen oder zwei Ringe mit 3 bis 10 (insbesondere 3, 4, 5, 6 oder 7) Ringkohlenstoffatomen aufweist und eine oder zwei Alkyl gruppen mit 1 oder 2 bis 6 Kohlenstoffatomen enthält.

Der Ausdruck Arylrest bezieht sich auf eine aromatische Gruppe, die einen oder mehrere Ringe mit insbesondere 6 bis 14 Ringkohlenstoffatomen, vorzugsweise 6 bis 10 (insbesondere 6) Ringkohlenstoffatomen aufweist. Der Ausdruck Arylrest (bzw. Ar) bezieht sich weiterhin auf Gruppen, bei denen ein oder mehrere Wasserstoffatome unabhängig voneinander durch jeweils ein Fluor-, Chlor-, Brom- oder Jodatom ersetzt sind. Ein erfindungsgemäßer Arylrest ist durch eine Silicium-Kohlenstoff-Bindung an das zentrale Siliciumatom des Silans gebunden und nicht hydrolysierbar. Bevorzugte Beispiele für nicht hydrolysierbare Gruppen bzw. Reste sind der Phenyl-, Benzoyl-, Naphthyl-, Biphenyl-, 2-Fluorphenyl, Fluoren-, Dihydronaphthaline-, Indane- oder Pentafluorophenyl-Rest. Phenylreste sind besonders bevorzugt. Die Verwendung von Silanen mit Arylresten, wie beispielsweise dem Phenylrest, resultiert vorteilhaft in einer hohen Hydrophobizität des erfindungsgemäßen Molekularsiebes. Dies wird vermutlich durch eine gute Abschirmung der hydrophilen Molekularsieboberfläche gegenüber einem Lösungsmittel verursacht.

Der Ausdruck Arylalkylrest bezieht sich auf Gruppen, die entsprechend den obigen Definitionen sowohl Aryl- wie auch Alky gruppen enthalten, wie z. B. Arylalkyl-, Alkylaryl gruppen. Konkrete Beispiele für Arylalkyle sind Toluol, Xylol, Mesitylen, Styrol, Benzylchlorid, o-Fluortoluol, 1H-Inden, Cumol. Bevorzugt enthält eine Arylalkylgruppe ein oder zwei aromatische Ringe mit 6 bis 10 Ringkohlenstoffatomen und ein oder zwei Alkyl-gruppen mit 1 oder 2 bis 6 Kohlenstoffatomen.

Bevorzugt können in jedem der oben aufgeführten Reste jeweils alle Wasserstoffatome durch Halogenatome ersetzt werden, besonders bevorzugt durch Fluoratome. Insbesondere wenn das erfindungsgemäße Molekularsieb in einer flüssigen Phase, wie beispielsweise dispergiert in einer flüssigen organischen Verbindung, verwendet wird, kann der Einsatz von Silanen mit perfluorierten Resten vorteilhaft sein. Beispielsweise werden bei einer maschinellen Verwendung einer Dispersion des erfindungsgemäßen Molekularsiebs in einer flüssigen organischen Verbindung, z.B. zum Auftragen derselben durch Sprayen mit einer Sprayvorrichtung, zum Drucken mit einer Druckvorrichtung oder dergleichen, die Wechselwirkungen zwischen den Partikeln des mit einem Silan mit perfluorierten Resten beschichteten Molekularsiebs und den Oberflächen der jeweiligen Vorrichtung, wie z.B. der inneren Oberfläche von Voratsbehältern, Rohr- oder Schlauchleitungen, Düsen oder dergleichen, vorteilhaft minimiert.

Besonders bevorzugte Silane sind Alkoxyailane, Fluorierte Silane, wie beispielsweise fluorierte Alkylalkoxysilane, oder fluorierte Alkylsilane, wie z.B. (Heptadecafluoro-1,1,2,2-Tetrahydrodecyl)Triethoxysilane.

Alle dieser Silanverbindungen können ein oder mehrere Chiralitätszentren enthalten. Die vorliegende Erfindung umfasst daher sowohl alle reinen Enantiomere und alle reinen Diastereomere, als auch deren Gemische in jedem Mischungsverhältnis. Des weiteren sind von der vorliegenden Erfindung auch alle cis/trans-Isomeren der Verbindungen sowie Gemische davon umfasst. Des weiteren sind von der vorliegenden Erfindung alle tautomeren Formen umfasst.

Bevorzugt umfasst die hydrolysierbare Gruppe den gesamten Rest, d.h. eine der Gruppen R¹, R², R³ oder R⁴, so dass unter Hydrolysebedingungen der gesamte Rest (R¹, R², R³ oder R⁴) von dem Restmolekül, umfassend das zentrale Siliciumatom, abgetrennt wird, und eine Si-OH-Gruppe ausgebildet wird. Besonders bevorzugt ist ein über das Sauerstoffatom gebundener Alkoxyrest, wie beispielsweise ein Methoxy-, Ethoxy-, n-Propanoxy-, Isopropanoxy-, n-Butanoxy-, Isobutanoxy-, sec-Butanoxy-, tert-Butanoxy, oder Hexanoxyrest.

Bevorzugt handelt es sich bei der Hydrolysereaktion um eine Reaktion, die in Gegenwart von Wasser bei gewöhnlichen Bedingungen spontan abläuft, aber es werden auch Reaktionen umfasst, die unter Bedingungen von, z.B., erhöhter Temperatur oder in Gegenwart eines Katalysators ablaufen. Bevorzugte Beispiele für derartige katalysierte Hydrolyse-Reaktionen sind Reaktionen, die in Gegenwart eines Elektrophils ablaufen, wie z.B. (Protonen)-säurekatalysierte Reaktionen, oder solche, die in Gegenwart eines Nucleophils ablaufen, wie z.B. basenkatalysierte Reaktionen.

Bei der Behandlung eines Molekularsieb-Partikels mit einem Silan, das mindestens eine hydrolysierbare Gruppe umfasst, kann die hydrolysierbare Gruppe direkt mit einer funktionellen Gruppe auf der Oberfläche des Partikels reagieren. Dabei wird vorzugsweise die hydrolysierbare Gruppe als Austrittsgruppe abgespalten und eine Bindung zwischen der Oberfläche des Partikels und dem Silan mit seinen restlichen Resten ausgebildet. Ein derartiger Partikel wird im Sinne dieser Erfindung als ein Partikel bezeichnet, dessen Oberfläche mit einem Silan beschichtet ist. Ein erfindungsgemäßes Molekularsieb ist mit einem oben definierten Silan hydrophob beschichtet.

Insbesondere werden mindestens zwei hydrolysierbaren Gruppe des Silans während der Beschichtungsreaktion, die zum erfindungsgemäßen hydrophob beschichteten Molekularsieb führt, durch eine funktionelle Gruppe auf der Oberfläche des Molekularsieb-Partikels ersetzt, wodurch das Silan, umfassend die restlichen Reste, mit der Oberfläche des Molekularsieb-Partikels verbunden wird. Beispielsweise kann das Silan mit einem oxidischen Festkörper als Molekularsieb-Partikel so reagieren, dass mindestens zwei hydrolysierbare Gruppen mit einer Hydroxidgruppe auf der Oberfläche des anorganischen Festkörpers unter Abgabe der hydrolysierbaren Gruppe kondensieren, wodurch der Silanrest, der die restlichen Reste aufweist, über eine Sauerstoff-Silicium-Bindung mit dem Molekularsieb-Partikel verbunden wird. Bevorzugt werden alle hydrolysierbaren Gruppen des Silans mit funktionellen Gruppen des Molekularsieb-Partikels reagieren und entsprechende Bindungen zu dem Molekularsieb-Partikel ausbilden. Beispielsweise kann ein Silan mit zwei hydrolysierbaren Gruppen mit einem oxidischen Festkörper als Molekularsieb-Partikel so reagieren, dass die zwei hydrolysierbaren Gruppen mit zwei Hydroxidgruppen auf der Oberfläche des anorganischen Festkörpers unter Abgabe der hydrolysierbaren Gruppen kondensieren, wodurch der Silanrest, der die restlichen Reste aufweist, über zwei Sauerstoff-Silicium-Bindungen mit dem Molekularsieb-Partikel verbunden wird. Dabei sind die zwei Hydroxidgruppen auf der Oberfläche des anorganischen Festkörpers bevorzugt zwei benachbarte Hydroxidgruppen auf der Oberfläche des anorganischen Festkörpers. Entsprechend kann ein Silan mit drei hydrolysierbaren Gruppen mit einem oxidischen Festkörper als Molekularsieb-Partikel so reagieren, dass die drei hydrolysierbaren Gruppen mit drei Hydroxidgruppen auf der Oberfläche des anorganischen Festkörpers unter Abgabe der drei hydrolysierbaren Gruppen kondensieren, wodurch der Silanrest, der den restlichen Rest aufweist, über drei Sauerstoff-Silicium-Bindungen mit dem Molekularsieb-Partikel verbunden wird. Dabei sind die drei Hydroxidgruppen auf der Oberfläche des anorganischen Festkörpers bevorzugt drei benachbarte Hydroxidgruppen auf der Oberfläche des anorganischen Festkörpers. Vorzugsweise umfasst ein erfindungsgemäßes hydrophob beschichtetes Molekularsieb, das durch Behandlung eines Molekularsieb-Partikels mit einem oben definierten Silan erhalten wird oder mit einem oben definierten Silan beschichtet ist, keine verbleibenden hydrolysierbaren Gruppen. Im Sinne dieser Erfindung wird ein hydrophob beschichtetes Molekularsieb, das durch Behandlung mit einem oben definierten Silan beschichtet wird, auch als ein Molekularsieb bezeichnet, das mit einem Silan beschichtet ist. Insbesondere ist ein erfindungsgemäßes hydrophob beschichtetes Molekularsieb, das mit einem oben definierten Silan beschichtet ist, ein Molekularsieb, das durch Behandlung eines Molekularsieb-Partikels mit einem Silan erhältlich ist.

Bevorzugt enthält das Silan keinen Rest, der eine funktionelle Gruppe umfasst, welche mit der hydrolysierbaren Gruppe unter gewöhnlichen Bedingungen oder unter den Bedingungen, die zur Beschichtung der Partikel verwendet werden, reagiert. Eine derartige Verbindung ist nachteilig für die vorliegende Erfindung, weil sie beispielsweise unter den genannten Bedingungen mit sich selbst reagieren (wie z.B. polymerisieren) würde, und somit nicht mehr für eine Beschichtung der Oberfläche der Partikel zur Verfügung stehen würde, oder zu einem polymeren Material mit eingebundenen Partikeln reagieren, welche somit nicht mehr in Form von diskreten Partikeln vorliegen.

Wenn in der vorliegenden Erfindung zwischen Resten R¹, R², R³ oder R⁴, die eine hydrolysierbare Gruppe umfassen, und restlichen Resten R¹, R², R³ und R⁴, die unabhängig voneinander ein Alkyl-, ein Alkenyl-, ein Alkinyl-, ein Heteroalkyl-, ein Cycloalkyl-, ein Heteroaryl-, ein Alkylcycloalkyl-, ein Hetero(alkylcycloalkyl)-, ein Heterocycloalkyl-, ein Aryl-, ein Arylalkyl-, oder ein Hetero(arylalkyl)-Rest sind, unterschieden wird, soll damit bestimmt werden, dass die restlichen Reste keine hydrolysierbare Gruppe umfassen. Anders ausgedrückt, umfasst erfindungsgemäß mindestens einer der Reste R¹, R², R³ oder R⁴ des Silans eine hydrolysierbare Gruppe, und die restlichen Resten R₁, R₂, R₃ und R₄ sind unabhängig voneinander ein nicht hydrolysierbarer Alkyl-, ein nicht hydrolysierbarer Alkenyl-, ein nicht hydrolysierbarer Alkinyl-, ein nicht hydrolysierbarer Heteroalkyl-, ein nicht hydrolysierbarer Cycloalkyl-, ein nicht hydrolysierbarer Heteroaryl-, ein nicht hydrolysierbarer Alkylcycloalkyl-, ein nicht hydrolysierbarer Hetero(alkylcycloalkyl)-, ein nicht hydrolysierbarer Heterocycloalkyl-, ein nicht hydrolysierbarer Aryl-, ein nicht hydrolysierbarer Arylalkyl-, oder ein nicht hydrolysierbarer Hetero(arylalkyl)-Rest, jeweils gemäß oben stehender Definition.

Erfindungsgemäß umfasst mindestens einer der Reste R¹, R², R³ oder R⁴ des Silans eine hydrolysierbare Gruppe. Bevorzugt umfasst mindestens einer der Reste R¹, R², R³ oder R⁴ des Silans eine hydrolysierbare Gruppe, die ausgewählt wird aus einer Alkoxygruppe und einer Cyanidgruppe. Bevorzugt umfasst bzw. umfassen einer, oder zwei, oder drei der Reste des Silans eine hydrolysierbare Gruppe, und besonders bevorzugt umfasst einer oder umfassen drei der Reste des Silans eine hydrolysierbare Gruppe.

In einer bevorzugten Ausführungsform der Erfindung ist bevorzugt jeder der hydrolysierbaren Reste des Silans unabhängig voneinander ein hydrolysierbarer Alkoxyrest, und die restlichen Reste werden unabhängig voneinander aus nicht-hydrolysierbaren Alkylresten, Alkenylresten, Alkylresten, Cycloaklylresten, Alkylcycloalkylresten, Arylresten, und Arylalkylresten, weiter bevorzugt aus Alkylresten, Cycloalkylresten und Arylresten, und besonders bevorzugt aus verzweigten Alkylresten ausgewählt. Insbesonders bevorzugt sind die Alkylreste verzweigte Alkylreste mit drei bis acht Kohlenstoffatomen.

Bevorzugt umfasst das Silan zwei, oder drei hydrolysierbare Alkoxyrest(e), wobei die restlichen Reste Alkylreste sind. Diese Silane haben den Vorteil, dass sie bei der Hydrolyse die jeweiligen Alkanole freisetzen, die entsprechend ihrer Toxizität ausgewählt werden können. Weiterhin ist vorteilhaft, dass die Alkohole sich unter den vorgegebenen Bedingungen inert gegenüber dem Molekularsieb verhalten, d.h. nicht mit diesem reagieren bzw. von diesem sorbiert werden können. Bevorzugte Beispiele für derartige Silane sind z.B. Isobutyltriethoxysilan, Diisobutyldiethoxysilan, Trisiobutylethoxyailan, Isobutyltrimethoxysilan, Diisobutyldimethoxysilan, Triisobutylmethoxysilan, Isobutyldimethylmethoxysilan, Isobutyldiethylmethoxysilan, Isopropyltriethoxysilan, Diisopropyldiethoxysilan, Triisopropylethoxysilan, Isopropyltrimethoxysilan, Diisopropyldimethoxysilan, oder Triisopropylmethoxysilan.

Besonders bevorzugt umfasst das Silan einen Alkylrest und drei hydrolysierbare Alkoxyreste. Bevorzugte Beispiele für ein solches Silan sind z.B. Isobutyltriethoxysilan, Isobutyltrimethoxysilan, Isopropyltriethoxysilan, oder Isopropyltrimethoxysilan.

Ebenfalls besonders bevorzugt umfasst das Silan drei Alkylreste und einen hydrolysierbaren Alkoxyrest. Bevorzugte Beispiele für ein solches Silan sind z.B. Isobutyldimethylmethoxysilan oder Isobutyldiethylmethoxysilan.

Die Oberfläche der Partikel wird mit dem Silan beschichtet, wobei ein Oberflächenbereich des Partikels mit einem Siliciumatom, einschließlich seiner verbleibenden, d.h. nicht hydrolysierten, Reste, beschichtet wird. Insbesondere ist die Oberfläche der Partikel hydrophob mit dem Silan beschichtet. Dabei kann ein Oberflächenbereich des Partikels auch mit mehreren Siliciumatomen beschichtet sein; so kann die Oberfläche des Partikels beispielsweise mit zwei, drei, vier oder fünf Siliciumatomen pro Oberflächenbereich beschichtet sein, wobei die Siliciumatome z.B. übereinander in mehreren Schichten, bzw. versetzt zueinander angeordnet sein können. Vorzugsweise ist die Beschichtung eine Monoschicht, d.h. jeder Oberflächenbereich ist nur mit genau einem Siliciumatom, einschließlich seiner verbleibenden, d.h. nicht hydrolysierten, Reste, beschichtet.

Auf der äußeren Oberfläche von oxidischen Materialien, wie z.B. Zeolithen, sind OH-Gruppen vorhanden. Um solche oxidische Partikel beispielsweise in apolaren Lösemitteln dispergieren zu können, werden die an der Oberfläche des jeweiligen Oxids befindlichen OH-Gruppen erfindungsgemäß mit einem Silan mit restlichen organischen Gruppen beschichtet bzw. funktionalisiert, wobei die restlichen organischen Gruppen dem jeweiligen Lösemittel möglichst ähnlich sind. Die Oberfläche der Oxidpartikel kann so mit apolaren und kovalent angebundenen Gruppen beschichtet werden. Die Ausbildung einer kovalenten, chemisch beständigen Bindung ist vorteilhaft, weil ein Verlust der apolaren Gruppen zu einer verstärkten Agglomerationsneigung der Partikel führen kann. Zwischen den reaktionsträgen organischen Gruppen auf der Oberfläche eines erfindungsgemäß hydrophob beschichteten Partikels können keine Kondensationsreaktionen stattfinden. Wechselwirkungen zwischen Partikeln beruhen deswegen hauptsächlich auf Vander-Waals Kräften. D.h. falls sich zwei Partikel berühren, können diese nicht dauerhaft und irreversibel agglomerieren. In apolaren Lösemitteln lassen sich erfindungsgemäß hydrophob beschichtete bzw. funktionalisierte Oxide gut dispergieren.

Bei Umsetzen eines Oxids mit einem erfindungsgemäß definierten Silan wird mindestens eine hydrolysierbare Gruppe abgespalten und es bildet sich zum Beispiel eine kovalente Bindung zwischen dem Silanrest und der Oberfläche des Oxids aus. Wenn beispielsweise das Silan mindestens einen hydrolysierbaren Alkoxyrest umfasst, werden bei der Umsetzung mit einem Oxid durch Hydrolyse nur der jeweilige Alkanol bzw. Alkylalkohol freigesetzt, welcher z.B. entsprechend seiner Toxizität ausgewählt werden kann. Ein Alkoxyrest als hydrolisierbare Gruppe bzw. Austrittsgruppe ist auch deshalb vorteilhaft, weil Alkohole sich im allgemeinen unter den vorgegebenen Bedingungen inert gegenüber dem Molekularsieb verhalten, d.h. nicht mit diesem reagieren bzw. von diesem sorbiert werden können.

Das erfindungsgemäße Molekularsieb ist durch seine geringe Größe im nanoskaligen Bereich ausgezeichnet. Diese geringe Größe erlaubt seine Verwendung in entsprechend klein dimensionierten Vorrichtungen. Beispielsweise kann das erfindungsgemäße Molekularsieb vorteilhaft in Vorrichtungen eingesetzt werden, in denen nur Hohlräume oder Spalten mit Dimensionen von nicht mehr als einem Mikrometer zur Verfügung stehen.

Weiterhin ist die Oberfläche des erfindungsgemäßen Molekularsiebs mit einem Silan beschichtet, wobei die nicht hydrolysierbaren Reste des Silans so ausgewählt werden können, dass sie der Oberfläche des Partikels eine gewünschte Eigenschaft verleihen. Insbesondere ist die Oberfläche des erfindungsgemäßen Molekularsiebs mit einem Silan hydrophob beschichtet, wobei die nicht hydrolysierbaren Reste des Silans so ausgewählt werden können, dass sie der Oberfläche des Partikels die gewünschte hydrophobe Eigenschaft verleihen. Dem Fachmann ist bekannt, welche Reste des Silans ausgewählt werden müssen, um eine gewünschte Eigenschaft der Oberfläche zu erzielen. So kann beispielsweise durch Silane mit nicht hydrolysierbaren Alkanresten eine lipophile bzw. hydrophobe Oberflächeneigenschaft erzielt werden, wobei der Grad der lipophilen bzw. hydrophoben Eigenschaft der Oberfläche durch Wahl von Anzahl und Merkmalen der einzelnen Alkanresten, wie z.B. der Kettenlänge oder des Verzweigungsgrades, gezielt modifiziert werden kann. Ein derartiges Molekularsieb kann vorteilhaft in organischen Verbindungen auf Alkanbasis, wie beispielsweise in Lösungsmitteln, wie z.B. Hexan oder Octan, oder in Polymeren, wie z.B. Polyethylen oder Polypropylen, dispergiert werden, ohne dass ein verklumpen des Materials beobachtet wird. Entsprechend können Silane mit anderen, nicht hydrolysierbaren Resten eingesetzt werden, um eine Oberflächeneigenschaft zu erzielen, die ein Dispergieren in anderen organischen Verbindungen oder Materialien ermöglichen. Beispielsweise können nicht hydrolysierbare Reste mit aromatischen Gruppen eingesetzt werden, um ein Dispergieren in aromatischen Verbindungen (wie zum Beispiel aromatische Lösungsmittel, wie z.B. Benzol, Toluol, Xylol, Pyridin, Naphthalin oder dergleichen), oder in Verbindungen mit aromatischen Gruppen (wie zum Beispiel Polymere mit aromatischen Gruppen, wie z.B. Polystyrol oder dergleichen), oder in Verbindungen mit zu aromatischen Gruppen analogen Eigenschaften (wie zum Beispiel Kohlenstoffverbindungen, wie z.B. Graphit, Fullerenen, Kohlenstoffnanotubes oder dergleichen) zu ermöglichen. Weiterhin kann zum Beispiel durch ein Silan mit einem nicht hydrolysierten Rest, der eine Vinylgruppe umfasst, eine Oberfläche erzielt werden, die zur Vernetzung mit vinylhaltigen Monomeren geeignet sind. Ein derartiges Molekularsieb kann in einem Polyvinylmaterial chemisch eingebunden werden. Allgemein kann durch die geeignete Wahl der nicht hydrolysierbaren Silanreste die Oberflächeneigenschaft des erfindungsgemäßen Molekularsiebs entsprechend der vorgesehenen Verwendung eingestellt werden. Insbesondere kann durch die geeignete Wahl der nicht hydrolysierbaren Silanreste die hydrophobe Oberflächeneigenschaft des erfindungsgemäßen Molekularsiebs entsprechend der vorgesehenen Verwendung eingestellt werden.

Die Begriffe "hydrophob beschichtet", "hydrophobisiert" bzw. "Hydrophobisierung" bezeichen im Rahmen der vorliegenden Erfindung eine Oberflächenbehandlung von Molekularsiebteilchen, die der erzeugten Oberfläche eine hydrophobe bzw. lipophile Eigenschaft verleiht, die bewirkt, dass das Molekularsiebteilchen nicht in Wasser, aber gut in apolaren Lösungsmitteln mit einer Dielektrizitätskonstante von kleiner als 22, bevorzugt von kleiner als 10, und besonders bevorzugt von kleiner als 3 suspendiert bzw. dispergiert werden kann. Entsprechend ist das hydrophob beschichtete Molekularsieb besonders bevorzugt ein Molekularsieb, das in apolaren Lösungsmitteln, insbesondere apolaren organischen Lösungsmitteln suspendiert bzw. dispergiert werden kann, welche eine Dielektrizitätskonstante von kleiner als 3 haben. Beispiele für derartige apolaren organischen Lösungsmittel sind beispielsweise gesättigte Kohlenwasserstoffe oder Alkane, wie z.B. Pentan, Hexan oder Octan, oder aromatischen Kohlenwasserstoffen, wie z.B. Benzol.

Um zu vermeiden, dass es bei der Beschichtung von porösen Partikeln zu einer Beschichtung und/oder Blockierung bzw. Verstopfung der Poren, inneren Kanäle und Kavitäten der Partikel durch das verwendete Silan kommt, können die Reste des Silans so ausgewählt werden, dass die Silanmoleküle nicht in die Kavitäten und Kanäle der Partikel eindringen können. So kann eine Beschichtung ausschließlich der äußeren Oberfläche erreicht werden. Die innere Oberfläche bleibt dagegen offen, d.h. wird weder beschichtet noch blockiert, und behält so ihren ursprünglichen Charakter. So kann beispielsweise ein Molekularsieb erhalten werden, das hervorragend in apolaren Stoffen dispergierbar ist, aber die Fähigkeit, polare Stoffe wie Wasser zu adsorbieren, beibehält. Eine weitere Möglichkeit, zu vermeiden, dass es bei der Beschichtung von porösen Partikeln zu einer Beschichtung und/oder Blockierung bzw. Verstopfung der Poren, inneren Kanäle und Kavitäten der Partikel durch das verwendete Silan kommt, ist es, die Poren der Partikel vor Beschichtung mit dem Silan reversibel zu verkleinern oder zu blockieren, beispielsweise durch Belegung mit grossen Ionen, wie z.B. mit Caesiumionen oder Tetraalkylammoniumionen.

So kann beispielsweise, wenn ein Einsatz eines Silans mit einem Moleküldurchmesser größer als die Eintrittsöffnungen eines Zeoliths nicht möglich ist, die Eintrittsöffnung des Zeoliths reversibel verkleinert werden. Dabei wird der einzustellende Porendurchmesser zweckmäßigerweise so gewählt, dass die Moleküle des Silans die Poren nicht mehr passieren können. Nach der Beschichtung kann dann der größere Porendurchmesser wieder hergestellt werden. Ein solches reversibles Einstellen der Porendurchmesser erfolgt vorzugsweise durch einen Ionenaustausch mit Ionen entsprechender Größe. So ist z.B. bekannt, dass Zeolith LTA mit Natrium beladen einen kinetischen Porendurchmesser von 4 Å (400 pm) besitzt. Ist er mit Kalium beladen, besitzt er dagegen einen Porendurchmesser von nur 3 Å (300 pm). Dieser Ionenaustausch kann reversibel durchgeführt werden.

Die Methode des Ionenaustausches kann auch verwendet werden, um den Brechungsindex des Zeoliths an den der organischen Verbindung, wie z.B. den des Polymers, anzupassen. Dies ist dann wünschenswert, wenn die Partikelgröße des in ein Polymer eingebrachten Zeoliths zu groß ist, als das bei einem großen Unterschied der Brechungsindizes optische Transparenz gewährleistet werden kann. Das Verfahren der Änderung der Gerüststruktur eines Zeolithen kann ebenfalls verwendet werden, um den Brechungsindex des Zeoliths an den einer organischen Verbindung anzupassen, in welcher er dispergiert werden soll. Dies ist dann besonders vorteilhaft, wenn die Partikelgröße des in eine organische Verbindung eingebrachten Zeoliths zu groß ist, als dass bei einem großen Unterschied der Brechungsindizes optische Transparenz gewährleistet werden kann. Einzelheiten zur Änderung der Gerüststruktur sind z.B. in JP 86-120459 beschrieben. Eine Möglichkeit, den Brechungsindex über einen Ionenaustausch zu verändern, ist z.B. in "Optical properties of natural and cation-exchanged heulandite group zeolites", J. Palmer, M. Gunter; American Mineralogist (2000), 85(1) ,225, beschrieben.

Die geringe Größe des erfindungsgemäßen Molekularsiebs zusammen mit seiner, der jeweiligen Umgebung angepassten Beschichtung erlaubt vorteilhaft die Verwendung in besonders dünnen Schichten. Weiterhin kann das Molekularsieb auch vorteilhaft in einem organischen Material, wie beispielsweise ein Polymer, ein Klebstoff oder ein Lack, dispergiert werden, und die so erhaltene Zusammensetzung kann dann in dünnen Schichten verwendet werden. So lassen sich mit dem erfindungsgemäßen Molekularsieb Schichten mit Dicken von weniger als 5 µm verwirklichen, was gerade bei miniaturisierten elektronischen Bauteilen und Geräten vorteilhaft ist. Besonders vorteilhaft können Schichten eines Kompositmaterials, das das erfindungsgemäße Molekularsieb, dispergiert in einer organischen Verbindung, wie z.B. einem Polymer, Klebstoff oder Lack, umfasst, hergestellt werden, die eine Schichtdicke von weniger als 5 µm, bevorzugt 2 µm, weiter bevorzugt 1 µm, und besonders bevorzugt 0,6 µm aufweisen.

Ein weiterer Vorteil ist, dass das erfindungsgemäße Molekularsieb auch geeignet ist, um in einer flüssigen organischen Verbindung dispergiert zu werden, so dass die das Molekularsieb enthaltende organische Verbindung mit einer üblichen Druckdüse, z.B. eine Strahldruckdüse, verarbeitet werden kann. So können Kompositmaterialien, die das Molekularsieb und eine organische Verbindung umfassen, mit üblichen Druckverfahren auf einen Werkstoff aufgedruckt werden, wie z.B. auf ein empfindliches Material, das auf einer Vorrichtung, wie z.B. einer Platine eines elektronischen Bauteils oder Gerätes angeordnet ist. Gegenüber üblichen Molekularsieben hat das Molekularsieb der vorliegenden Erfindung den Vorteil, dass es nicht nur keine Teilchen enthält, die aufgrund ihrer Größe die Düse verstopfen können, sondern auch keine Agglomerate in den organischen Schichten bildet, welche ihrerseits die Düse verstopfen können.

Darüber hinaus hat eine Untersuchung der Eigenschaften des Molekularsiebs der Erfindung gezeigt, dass das Molekularsieb der vorliegenden Erfindung einen, im Vergleich mit üblichen Gettermaterialien, besonders guten Schutz von empfindlichen Materialien ermöglicht, auch wenn es in dickere Schichten von organischen Verbindungen eingebracht wird.

Bevorzugt umfassen die Partikel anorganische Partikel. Anorganische Partikel im Sinne dieser Erfindung sind anorganische Festkörper, bevorzugt anorganische oxidische Festkörper. Hierbei bedeutet der Ausdruck oxidischer Festkörper insbesondere eine anorganische Verbindung, die in Form eines kristallinen, teil- oder nicht-kristallinen Festkörpers vorliegt. Neben Metallkationen, umfassend Kationen eines oder mehrerer Elemente der Hauptgruppen oder der Nebengruppen des Periodensystems, umfasst ein derartiger oxidischer Festkörper Anionen, die Sauerstoffatome umfassen. Bevorzugte Beispiele für solche Anionen sind neben dem Oxidanion (O²⁻), dem Hyperoxidanion (O₂⁻) und dem Peroxidanion (O₂²⁻), auch Anionen, die auf Oxiden von Elementen der Haupt- und Nebengruppen basieren, wie beispielsweise Schwefeloxidanionen, Phosphatanionen, Silikatanionen, Boratanionen, Aluminatanionen, Wolframatanionen und dergleichen. Derartige Anionen können beispielsweise isoliert vorliegen oder in Form von z.B. Ketten, Bändern, Schichten, Gerüsten, Käfigen oder dergleichen kondensiert sein. Derartige kondensierte Anionen können Oxide von einem oder mehreren Elementen der Haupt- und Nebengruppen umfassen, wobei mehrere unterschiedliche Elemente in einem kondensierten Anion umfasst sein können.

Auf der äußeren Oberfläche derartiger oxidischer Materialien sind häufig OH-Gruppen vorhanden. Dispergiert man ein derartiges Oxidmaterial in Wasser, kommt es zu vielfältigen Wechselwirkungen dieser OH-Gruppen mit Wasser. So kann ein solches Oxidmaterial in Abhängigkeit vom pH-Wert der wässerigen Lösung Protonen über die an der Oberfläche liegenden OH-Gruppen aufnehmen oder verlieren. Zusätzlich können sich Wasserstoffbrückenbindungen ausbilden, welche zu einer anhaftenden Wasserschicht auf dem Oxidmaterial führen. Die Existenz einer solchen, anhaftenden Wasserschicht auf dem Oxid kann dazu führen, dass das Oxidmaterial als eine stabile wässerige Suspension erhalten werden kann, weil sich die einzelnen Partikel des Oxidmaterials nicht berühren können und somit auch nicht agglomerieren. Deshalb werden Partikel aus derartigen anorganische oxidischen Materialien vorzugsweise entwässert, z.B. durch Ausheizen unter Vakuum oder durch Gefriertrocknen, wenn sie für das Molekularsieb der vorliegenden Erfindung verwendet werden.

Erfindungsgemäß sind die Partikel anorganische Partikel, die aus Partikeln ausgewählt werden, die poröse Alumophosphate, poröse Silicoalumophosphate oder Zeolithe umfassen. Bevorzugte Beispiele für derartige Alumophosphate sind z.B. AlPO-5, AlPO-8, oder AlPO-18. Bevorzugte Beispiele für derartige Silicoalumophosphate sind z.B. SAPO-5, SAPO-16, oder SAPO-17. Bevorzugte Beispiele für derartige Zeolithe sind natürliche und künstliche Zeolithe, wie z.B. die natürlichen Zeolithe Gismondine, bzw. Zeolith Na-P1 (GIS-Struktur), und oder die Zeolithe vom Typ ABW, BEA, oder FAU, oder die künstlichen Zeolithe Zeolith LTA (Linde Typ A), Zeolith F, Zeolith LTL, P1, P2, und P3. Besonders bevorzugt werden als Partikel kleinporige Zeolithe mit Porendurchmessern von kleiner als 5 Å (500 pm) verwendet, wie beispielsweise Gismondine, Zeolith F, oder Zeolith LTA.

In einer bevorzugten Ausführungsform der vorliegenden Erfindung werden die Partikel ausgewählt aus Gismondine, Zeolith LTA, Zeolith LTF, Zeolith P1, P2 oder P3, und das Silan umfasst einen Alkylrest und drei hydrolysierbare Alkoxyreste. Besonders bevorzugt werden dabei Partikel aus Zeolith LTA, die mit Isobutyltriethoxysilan, mit Isopropyltriethoxysilan oder mit Phenyltrimethoxysilan beschichtet sind und Partikel aus Zeolith LTF, die mit Isobutyltriethoxysilan, mit Isopropyltriethoxysilan oder mit Phenyltrimethoxysilan beschichtet sind.

Diese bevorzugten Ausführungsformen stellen bevorzugte Beispiele des erfindungsgemäßen Molekularsiebs dar, aber ein Fachmann wird verstehen, dass das Molekularsieb der vorliegenden Erfindung nicht auf diese Ausführungsformen beschränkt ist.

Erfindungsgemäß wird das Molekularsieb als ein Gettermaterial verwendet. So kann das erfindungsgemäße Molekularsieb aufgrund seiner Größe leicht in miniaturisierten Vorrichtungen, wie z.B. in elektronischen Bauteilen und Geräten, als Gettermaterial eingesetzt werden. Insbesondere kann das erfindungsgemäße Molekularsieb vorteilhaft in Hohlräumen verwendet werden, die zumindest in einer Dimension eine maximale Abmessung von weniger als 1 µm haben, insbesondere von weniger als 500 nm haben.

Weiter bezieht sich die vorliegende Erfindung auf eine Zusammensetzung, die das erfindungsgemäße Molekularsieb und eine organische Verbindung umfasst. Hier bedeutet der Ausdruck organische Verbindung eine übliche organische Verbindung, wie beispielsweise ein organisches Lösungsmittel, einen organischen Feststoff, eine organische Flüssigkeit, oder ein organisches Polymer. Dabei können organische Feststoffe und/oder organische Polymere in jeder beliebigen Form vorliegen bzw. in diese verarbeitet werden. Beispielsweise können organische Polymere in Form von Granulaten, Strängen, Platten, Folien oder dergleichen, mit beliebigen Durchmessern bzw. Stärken verwendet werden.

Darüber hinaus umfasst der Ausdruck organische Verbindung auch eine Zusammensetzung (Kompositmaterial), die eine oder mehrere organische Verbindung(en) umfasst, wobei optional auch nicht organische Komponenten, wie z.B. anorganischen Füllstoffen, Färbungsmitteln, Leitungsmitteln, oder dergleichen, umfasst sein können. Vorteilhaft kann das Molekularsieb der vorliegenden Erfindung so beschichtet werden, das die Eigenschaften der Oberfläche der Partikel denen der organischen Verbindung angeglichen werden, so dass das Molekularsieb in der organischen Verbindung dispergiert wird. Dem Fachmann ist bekannt, welche Beschichtung für welche organische Verbindung geeignet ist, wie oben beschrieben.

Bevorzugt umfasst die in der Zusammensetzung umfasste organische Verbindung eine polymere Verbindung. Der Ausdruck polymere Verbindung umfasst alle üblichen Polymere, wie beispielsweise Homopolymere, syn- bzw. isotaktische Polymere, und Heteropolymere, statistische Polymere sowie Blockpolymere bzw. Blockcopolymere. Die polymere Verbindung umfasst sowohl kettenförmige Polymere, als auch zwei- oder dreidimensional vernetzte Polymere. Diese Polymere können thermoplastisch, elastisch, duroplastisch oder dergleichen sein. Der Ausdruck polymere Verbindung umfasst auch monomere Verbindungen und/oder oligomere Verbindungen, die optional weiter polymerisiert werden können. Die polymere Verbindung kann als reine Verbindung, z.B. in fester Form, vorliegen, oder in Form einer Lösung oder Dispersion. Vorzugsweise liegt eine polymere Verbindung in fester Form vor, z.B. in Form von Granulaten, Strängen, Platten, Folien oder dergleichen, mit beliebigen Durchmessern bzw. Stärken.

Bevorzugt ist die polymere Verbindung eine thermoplastische Verbindung. Hierbei bedeutet thermoplastisch, dass die Verbindung unter Einfluss von Wärme reversibel, d.h. ohne Zerstörung der Verbindung, erweicht bzw. verflüssigt wird, so dass die Verbindung unter Einfluss von Wärme verarbeitet werden kann, wie beispielsweise ver- bzw. geformt, oder mit weiteren Komponenten gemischt werden kann. Bevorzugte Beispiele für thermoplastische Polymere sind Polyolefine, wie z.B. Polyethylen (PE, HDPE bzw LDPE), oder Polypropylen (PP), Polyoxiolefine, wie z.B. Polyoximethylen (POM) oder Polyoxiethylen, Polymethylmethacrylat (PMMA), AcrylnitrilButadien-Styrol-Copolymerisat (ABS), oder dergleichen. In eine thermoplastische Verbindung kann das erfindungsgemäße Molekularsieb unter Einfluss von Wärme vorteilhaft, auch nachträglich, eingearbeitet werden, so dass eine homogene Dispersion entsteht, ohne dass die polymere Verbindung zerstört wird.

Besonders bevorzugt besitzt die polymere Verbindung eine geringe Wasserpermeabilität, d.h. eine Wasserpermeabilität von unter 0,9 g·mm/m² ·d bei einem Gefälle von 0% zu 90% relativer Luftfeuchtigkeit bei 25°C (wobei d = Tag), vorzugsweise von unter 0,63 g·mm/m²·d, und besonders bevorzugt von unter 0,1 g·mm/m²·d (gemessen an einer 100 µm dicken Schicht). Bevorzugte Beispiele derartiger polymerer Verbindungen sind beispielsweise Polyolefine, wie z.B. Polyethylen (PE), sowohl High-Density-Polyethylen (HDPE), als auch Low-Density-Polyethylen (LDPE), oder Polypropylen (PP) oder dergleichen. Eine derartige Zusammensetzung, die das Molekularsieb der Erfindung und eine polymere Verbindung mit geringer Wasserpermeabilität umfasst, zeigt besonders vorteilhaft die erwünschten Eigenschaften.

Bevorzugt ist die organische Verbindung ein Lack, vorzugsweise ein wasserfreier Lack, und besonders bevorzugt ein Lack, der eine geringe Wasserpermeabilität besitzt, d.h. eine Wasserpermeabilität von unter 2 g·mm/m²·d bei einem Gefälle von 0% zu 90% relativer Luftfeuchtigkeit (wobei d = Tag), vorzugsweise von unter 1 g·mm/m²·d. Besonders bevorzugt ist der Lack ein Lack, der durch UV-Licht gehärtet werden kann. Bevorzugte Beispiele derartiger Lacke sind z.B. der Lack EPO-TEC OG 142-17, erhältlich von der Polytec PT GmbH, 76337 Waldbronn, DE, oder der Lack UV-Coating Polyled Barriersyst. #401, erhältlich von Eques C.V., 5340 AE Oss, NL, oder der Lack Loctite 3301 Medical Grade, erhältlich von der Henkel Loctite Deutschland GmbH, 81925 München, DE.

Bevorzugt werden die Partikelgröße so ausgewählt, dass sie in der organischen Verbindung homogen verteilt werden können. Zur Erreichung einer homogenen Verteilung der Partikel in der jeweiligen Verbindung ist es nicht nur wichtig, dass die einzelnen Partikel klein gegenüber der Dicke einer auszubildenden Schicht sind, sondern auch, dass sie homogen dispergiert werden können. Dazu ist das erfindungsgemäße Molekularsieb vorteilhaft geeignet.

Erfindungsgemäß wird eine Zusammensetzung, die das Molekularsieb der Erfindung und eine organische Verbindung umfasst, zum Herstellen oder Versiegeln einer Vorrichtung verwendet.

Bevorzugt ist die Vorrichtung eine Verpackung. So wird eine Zusammensetzung, die das Molekularsieb der Erfindung und eine organische Verbindung umfasst, erfindungsgemäß dazu verwendet, eine Verpackung für empfindliche Produkte herzustellen oder zu versiegeln, welche Verbindungen oder Zusammensetzungen umfassen, die von kleinen Molekülen angegriffen oder zerstört werden, wie beispielsweise Vorrichtungen, wie z.B. elektrische oder elektronische Bauteile oder Geräte, oder Lebensmittel oder Medikamente. In einer bevorzugten Ausführungsform werden derartige Verpackungen direkt aus einer Zusammensetzung hergestellt, die das Molekularsieb der Erfindung und eine organische Verbindung umfasst. Beispielsweise können Verpackungen, wie z.B. abgeschlossene Folienverpackungen (Tüten, Taschen und dergleichen) oder Kunststoffverpackungen, wie z.B. Klarsichtverpackungen für Lebensmittel oder Medikamente, die aufeinanderpassende Ober- und ein Unterteile umfassen, direkt aus einem Polymer, das das Molekularsieb der Erfindung umfasst, hergestellt werden. In einer anderen bevorzugten Ausführungsform werden Verpackungen aus anderen Materialien, wie z.B. Papier, Pappe, einem Kunststoff oder Polymer, Metall, oder dergleichen, versiegelt, indem sie mit einem Polymer- oder Lackfilm, welcher das Molekularsieb der Erfindung umfasst, beschichtet werden. Dabei kann die Beschichtung sowohl auf die Aussenseite der verpackung, als auch auf die Innenseite der Verpackung aufgebracht werden, und bevorzugt wird die Beschichtung sowohl auf der Aussenseite der Verpackung, als auch auf der Innenseite der Verpackung aufgebracht. Bevorzugt ist eine derartige Beschichtung, insbesondere der Aussenseite, transparent, so dass es möglich ist, eine, beispielsweise auf eine Pappverpackung aufgedruckte, Information durch die Beschichtungsschicht, die das Molekularsieb umfasst, zu lesen. In einer weiteren bevorzugten Ausführungsform werden Verpackungsbehälter aus einem anderen Material, wie beispielsweise einem Kunststoff, einem Metall oder dergleichen, mit einer Folie, einer Kappe oder dergleichen, aus einem Polymer, welches das Molekularsieb der Erfindung umfasst, verschlossen, um so eine vollständige Verpackung herzustellen. Alternativ kann auch eine derartige Zusammensetzung, die das Molekularsieb der Erfindung und eine organische Verbindung umfasst, in den Innenraum einer aus einem anderen Material bestehenden Verpackung eingebracht werden, wie beispielsweise in das Innere einer Kappe, die eine röhrenförmige Verpackung verschliesst, wie z.B. eine Medikamentenröhrenverpackung.

Ebenfalls bevorzugt ist die Vorrichtung ein elektrisches oder elektronisches Bauteil oder Gerät. Bevorzugte Beispiele für ein elektrisches oder elektronisches Bauteil oder Gerät sind ein Micro-Elektro-Mechanical-System (MEMS), wie beispielsweise einem Beschleunigungssensor, z.B. für einen Airbag, ein Micro-Electro-Optical-System (MEOMS), ein DMD-Chip, ein System-on-Chip (SoC), Solarzellen oder dergleichen. Bevorzugt ist eine Vorrichtung eine Solarzelle, insbesondere eine Dünnschichtsolarzelle, ein Diagnostic Kit, eine organische photochrome ophthalmische Linse, ein "Flip-Chip", oder ein OLED (organic light emitting device), und besonders bevorzugt eine organische Solarzelle, eine CIS-Solarzelle und ein OLED. Bevorzugt wird eine solche Vorrichtung versiegelt, indem sie in ein dicht schließendes Gehäuse verkapselt wird, welches wiederum mit der Zusammensetzung, die das Molekularsieb der Erfindung und eine organische Verbindung umfasst, versiegelt, verklebt, überzogen oder dergleichen wird. Besonders bevorzugt wird auch das Gehäuse aus der Zusammensetzung hergestellt.

Alternativ wird eine zu schützende Oberfläche direkt mit einer Zusammensetzung, die das Molekularsieb der Erfindung und eine organische Verbindung umfasst, beschichtet. Hierbei bedeutet eine zu schützende Oberfläche eine Oberfläche einer Vorrichtung, die aus einem Material besteht, das durch kleine Moleküle angegriffen wird. Die Zusammensetzung kann durch jedes übliche Verfahren auf die Oberfläche aufgebracht werden, wie beispielsweise durch Gießen, Tauchen, Sprayen, Lackieren, Walzen, Pinseln oder dergleichen. Je nach Natur der Zusammensetzung kann das Aufbringen auch weitere Schritte umfassen, wie beispielsweise beim Aufbringen einer löslichen Zusammensetzung, das Auflösen in einem geeigneten Lösungsmittel vor dem Aufbringen und das Entfernen des Lösungsmittels nach dem Aufbringen, z.B. durch Verdampfen; beim Aufbringen einer Zusammensetzung, die ein thermoplastisches Polymer umfasst, das Erwärmen vor dem Aufbringen und das Abkühlen nach dem Aufbringen; beim Aufbringen einer Zusammensetzung, die polymerisierbare Monomere oder Oligomere umfasst, das Starten einer Polymerisierungsreaktion nach dem Aufbringen, z.B. durch UV-Bestrahlung oder Erwärmen, optional gefolgt von einem Entfernen eines optionalen Lösungsmittels; oder dergleichen. Optional kann ein Schritt zur Reinigung der zu schützenden Oberfläche dem Aufbringen der Zusammensetzung vorgeschaltet werden.

Besonders bevorzugt wird eine Zusammensetzung, die das Molekularsieb der Erfindung und eine organische Verbindung umfasst, durch eine Druckdüse auf die zu schützende Oberfläche aufgedruckt. Hierbei können alle üblichen Druckdüsen und Druckverfahren verwendet werden, die zum Aufdrucken von Schichten geeignet sind. Beispielsweise kann die Zusammensetzung mit einer üblichen Strahldruckvorrichtung gedruckt werden, wie sie bei der Herstellung von Platinen für elektrische und/oder elektronische Schaltkreise und von auf solchen Platinen basierenden Vorrichtungen verwendet wird. Derartige Druckdüsen haben häufig einen Düsendurchmesser im Bereich von einigen Mikrometern. Die Zusammensetzung, die das Molekularsieb der vorliegenden Erfindung mit Partikeln mit einer Partikelgröße von 1000 nm oder weniger umfasst, kann somit diese Druckdüse passieren, ohne das die Düse von Partikeln oder Agglomeraten verstopft würde. Dies erlaubt ein vorteilhaftes Aufbringen der Zusammensetzung in einem automatisierten Betrieb, z.B. durch einen Roboter, welcher mit einer ein übliches Gettermaterial enthaltenden Zusammensetzung nicht möglich ist.

In einer weiteren bevorzugten Anwendung wird eine Zusammensetzung, die das Molekularsieb der Erfindung und eine organische Verbindung umfasst, zur Herstellung von Membranen verwendet.

Die Erfindung bezieht sich auch auf eine Vorrichtung, die ein Molekularsieb gemäß der Erfindung oder eine Zusammensetzung, die das Molekularsieb der Erfindung und eine organische Verbindung umfasst, umfasst. Der Ausdruck Vorrichtung hat hier die oben bestimmte Bedeutung. In einer derartigen Vorrichtung werden die vorteilhaften Wirkungen der vorliegenden Erfindung besonders hervortreten.

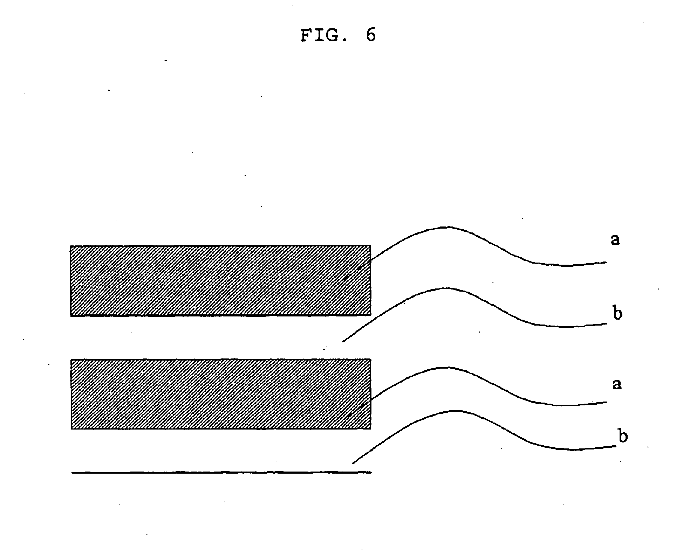

Bevorzugt umfasst die erfindungsgemäße Vorrichtung mehr als eine Schicht aus einem Kompositmaterial, das das erfindungsgemäße Molekularsieb und eine organische Verbindung, wie Beispielsweise ein Polymer, ein Klebstoff, ein Lack oder dergleichen, umfasst, besonders bevorzugt zwei Schichten, drei Schichten oder vier Schichten. Vorzugsweise werden die Schichten nacheinander übereinander aufgetragen. In einer alternativen Ausführungsform werden die Schichten alternierend mit anderen Materialschichten aufgetragen. Bevorzugt bestehen diese anderen Materialschichten aus empfindlichen Materialien, so dass ein empfindliches Material zwischen zwei Schichten des Kompositmaterials gemäß der Erfindung laminiert wird. Alternativ können auch andere Materialien eingesetzt werden, die z.B. eine weitere Funktion der Vorrichtung ausüben, wie z.B. eine Steuerfunktion, eine optische Funktion oder eine Kühlungs-/Heizungs-Funktion, oder eine weitere Schutzfunktion haben, wie beispielsweise gegen elektromagnetische Strahlung, wie z.B. gegen Licht, UV-Licht oder dergleichen, oder eine Diffusionsbarriere darstellen kann. So können Laminatfolgen hergestellt werden, die aus mehreren Schichten bestehen und, in Abhängigkeit von den jeweiligen Schichten bzw. Schichtfolgen eine Vielzahl möglicher Anwendungen ergeben können. Ein Beispiel für einen mehrschichtigen Aufbau ist in Figur 6 gezeigt.

Weiterhin bezieht sich die vorliegende Erfindung auf ein Verfahren zur Herstellung des vorstehend definierten erfindungsgemäßen Molekularsiebs wie in Anspruch 5 definiert.

Erfindungsgemäß werden Partikel mit mindestens einem Silan zur Reaktion gebracht. Vorzugsweise können ein, zwei, drei oder mehrere voneinander unterschiedliche Silane in der Reaktion verwendet werde. Bevorzugt werden Partikel mit einem Silan zur Reaktion gebracht.

Die verwendeten Partikel mit einer Partikelgröße von 1000 nm oder weniger können durch bekannte Verfahren hergestellt werden. Beispielsweise können Zeolithpartikel mit einer Partikelgröße von weniger als 1000 nm gemäß dem in der Patentanmeldung WO 02/40403 A1 beschriebenen Verfahren hergestellt werden.

Erfindungsgemäß werden die Partikel mit einem Silan zur Reaktion gebracht, womit alle Reaktionsbedingungen umfasst sind. Beispielsweise können die beiden Reaktanden spontan miteinander reagieren, wenn sie mit einander in Kontakt gebracht werden. In diesem Fall kann das Verfahren unter geeigneten Verdünnungsbedingungen oder unter Kühlung durchgeführt werden. Je nach der Reaktionsträgheit der Reaktanden miteinander kann es aber auch notwendig werden, Energie, beispielsweise in Form von elektromagnetischer Strahlung, wie z.B. Wärme, sichtbarem Licht oder UV-Licht, zuzuführen, oder einen geeigneten Katalysator einzusetzen. Die jeweils geeigneten Massnahmen kann der Fachmann entsprechend seinem Fachwissen auswählen.

Bevorzugt werden die Reaktanden in einem geeigneten Lösungsmittel zur Reaktion gebracht. Geeignete Lösungsmittel sind alle Lösungsmittel, die inert gegenüber dem Partikeln und dem Silan sind. Bevorzugt werden aprotische organische Lösungsmittel, wie beispielsweise gesättigte Kohlenwasserstoffe, wie z.B. Alkane, wie z.B. Hexan, Heptan, Octan oder dergleichen, aromatische Kohlenwasserstoffe, wie z.B. Benzol, Toluol, Xylol oder dergleichen, halogenierte Kohlenwasserstoffe, wie z.B. Tetrachlorkohlenstoff, Dichlormethan, Hexafluorethan, Hexafluorbenzol, oder dergleichen, Dimethylsulfoxid (DMSO), Dimethylformamid (DMF) oder dergleichen.

Bevorzugt werden die Reaktanden in einem Lösungsmittel unter Erhitzen miteinander zur Reaktion gebracht, wobei insbesondere ein Kochen unter Rückfluss bevorzugt ist. Vorzugsweise wird die Reaktion unter einem geeigneten inerten Schutzgas, wie z.B. Argon oder Stickstoff, durchgeführt. Bevorzugt werden bei der Herstellung des Molekularsiebs der Erfindung die Partikel zuerst getrocknet, bevor ihre Oberfläche mit dem Silan beschichtet wird. Getrocknete Partikel eignen sich besonders vorteilhaft zur Herstellung des erfindungsgemäßen Molekularsiebs, weil unerwünschte Moleküle, wie z.B. Wassermoleküle, die z.B. eine Reaktion mit dem Silan verlangsamen, uneinheitlich machen oder sonstwie behindern können, von der Oberfläche entfernt werden. So kann vorteilhaft ein Molekularsieb erhalten werden, das keine Agglomerate umfasst. Gleichfalls können auf diese Weise unerwünschte Moleküle aus den Poren der Partikel entfernt werden. Optional kann ein Reinigungsschritt vor dem Trocknungsschritt durchgeführt werden, in dem die Partikel beispielsweise mir einem geeigneten System gewaschen werden, um eine unerwünschte Belegung der Oberfläche und/oder der Poren mit Molekülen oder Ionen zu entfernen. Insbesondere können auch in den Partikeln vorhandene Ionen durch Ionenaustauschreaktionen ausgetauscht werden, um die Eigenschaften der Partikel, wie z.B. die Porengröße, gezielt zu verändern.

Besonders bevorzugt werden die Partikel durch ein Verfahren getrocknet, das ausgewählt wird aus Ausheizen im Vakuum und Gefriertrocknen. Zum Ausheizen werden die Partikel bevorzugt für mindestens 12 Stunden, bevorzugt mindestens 24 Stunden, und besonders bevorzugt mindestens 48 Stunden in einem elektrischen Ofen unter einem Vakuum von 10⁻² mbar auf eine Temperatur von mindestens 150°C, und besonders bevorzugt mindestens 180°C geheizt, um unerwünschte Moleküle von der Oberfläche zu entfernen. In einem bevorzugten Verfahren werden die Partikel vor der Beschichtung mit dem Silan durch Ausheizen getrocknet. In einem bevorzugten Verfahren werden die Partikel nach der Beschichtung mit dem Silan durch Ausheizen getrocknet. So kann vorteilhaft verhindert werden, dass die Partikel Agglomerate bilden. In einem besonders bevorzugten Verfahren werden die Partikel sowohl vor, als auch nach der Beschichtung mit dem Silan durch Ausheizen getrocknet.

Bevorzugt werden die Partikel in einem ersten Schritt gefriergetrocknet. Zum Gefriertrocknen werden die Partikel beispielsweise für mindestens 12 Stunden, bevorzugt mindestens 24 Stunden, und besonders bevorzugt mindestens 48 Stunden in einer entsprechenden Vorrichtung unter Vakuum (10⁻² mbar) bei einer Temperatur von höchstens 25°C, bevorzugt höchstens 20°C, um unerwünschte Moleküle von der Oberfläche zu entfernen. So kann vorteilhaft erreicht werden, dass die Partikel keine Agglomerate bilden. Ein Gefriertrocknen ist insbesondere dann vorteilhaft, wenn das Molekularsieb in wässeriger Suspension hergestellt wird. Diese Suspension kann eingefroren und durch Gefriertrocknen getrocknet werden, um vorteilhaft zu verhindern, dass die Partikel Agglomerate bilden. In einem besonders bevorzugten Verfahren werden die Partikel zuerst durch Gefriertrocknen getrocknet, dann durch Ausheizen im Vakuum getrocknet, und danach mit dem Silan beschichtet. Optional können die Partikel nach der Beschichtung durch Ausheizen im Vakuum getrocknet werden. So kann vorteilhaft verhindert werden, dass die Partikel Agglomerate bilden.

In einem alternativen besonders bevorzugten Verfahren werden die Partikel zuerst durch Gefriertrocknen getrocknet, dann mit dem Silan beschichtet, und nach Beschichtung durch Ausheizen im Vakuum getrocknet. Insbesondere wenn ein Zeolith als Molekularsieb verwendet wird, ist es ganz entscheidend, dass der Zeolith vor dem Beschichten durch Gefriertrocknen getrocknet wird, und nach dem Beschichten durch Ausheizen im Vakuum. Es wurde gefunden, dass durch dieses besonders bevorzugte Verfahren eine Verschlechterung der Produkteigenschaften verhindert werden kann.

In einem bevorzugten Verfahren zur Herstellung der erfindungsgemäßen Partikel werden die Partikel zur Beschichtung mit dem Silan in einem ersten Schritt in einem geeigneten Lösungsmittel suspendiert und das Silan wird in einem folgenden Schritt zu dieser Suspension zugegeben. Geeignete Lösungsmittel sind alle Lösungsmittel, die inert gegenüber dem Partikeln und dem Silan sind. Bevorzugt werden aprotische organische Lösungsmittel, wie beispielsweise gesättigte Kohlenwasserstoffe, wie z.B. Alkane, wie z.B. Hexan, Heptan, Octan oder dergleichen, aromatische Kohlenwasserstoffe, wie z.B. Benzol, Toluol, Xylol oder dergleichen, halogenierte Kohlenwasserstoffe, wie z.B. Tetrachlorkohlenstoff, Dichlormethan, Hexafluorethan, Hexafluorbenzol, oder dergleichen, Dimethylsulfoxid (DMSO), Dimethylformamid (DMF) oder dergleichen. Vorzugsweise wird das Silan portionsweise zugegeben, z.B. durch Zutropfen, optional in Mischung mit Lösungsmittel. Bevorzugt wird die Reaktion unter einem Inertgas durchgeführt, wie z.B. Argon oder Stickstoff.

In einem alternativen Verfahren zur Herstellung der erfindungsgemäßen Partikel wird zur Beschichtung mit dem Silan in einem ersten Schritt das Silan mit einem geeigneten Lösungsmittel gemischt, und die Partikel werden in einem folgenden Schritt zugegeben. Ein geeignetes Lösungsmittel ist wie oben definiert. Vorzugsweise werden die Partikel portionsweise zugegeben, optional in Mischung mit Lösungsmittel. Bevorzugt wird die Reaktion unter einem Inertgas durchgeführt, wie z.B. Argon oder Stickstoff.

### Beispiele

### Messung der Partikelgrößen

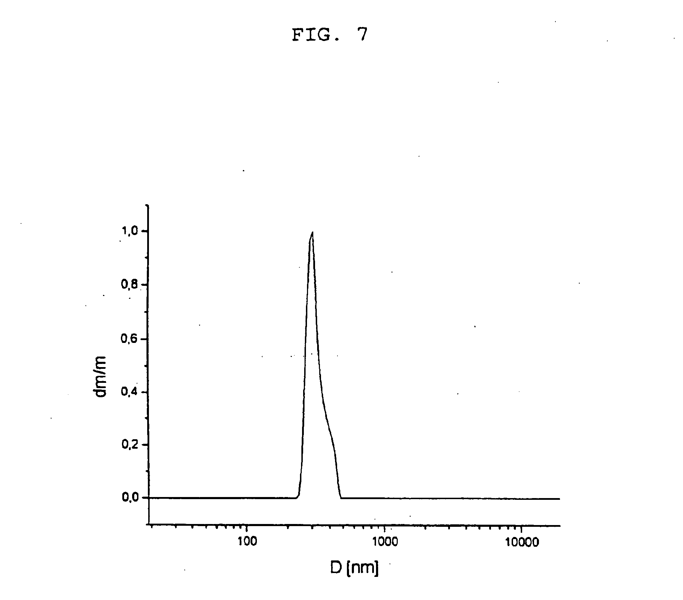

Die Größenverteilungen der Molekularsiebpartikel wurden über dynamische Lichtstreumessungen bestimmt. Dazu wurden jeweils etwa 2 ml einer Dispersion, die die zu untersuchenden Partikel in einem geeigneten Lösungsmittel oder in einer Zusammensetzung enthält, mit einem ALV-NIBS Particle Sizer, erhältlich von der Firma ALV-GmbH Langen, gemessen. Eine typische Größenverteilung ist in Figur 7 gezeigt.

Sofern nicht anders angegeben wurde für alle nachfolgend beschriebenen Beispiele Zeolith LTA mit einer Partikelgröße von etwa 300 nm (s. Figur 7) verwendet, der gemäß dem in der Patentanmeldung WO 02/40403 A1 beschriebenen Verfahren hergestellt wurde.

### Beispiel 1 - Beschichtung des Molekularsiebs

### a) Beschichtung von Zeolith LTA mit Isobutyltriethoxysilan:

100 ml einer 20%igen wässrigen Suspension von Zeolith LTA mit einer Partikelgröße von 300 nm wurden gefriergetrocknet. Es wurde während des Gefrierens auf eine hohe Abkühlrate geachtet. Das im Feinvakuum (10⁻² mbar) bei einer Temperatur von 150°C entwässerte Pulver wurde unter Rühren in eine Mischung aus 100 ml getrocknetem Toluol und 10 ml Isobutyltriethoxysilan gegeben und eine Stunde lang unter Rückfluss gekocht. Nach Abkühlen der Mischung wurde das Produkt abfiltriert. Es wurde ein weißes, stark hydrophobes Pulver erhalten, welches sehr gut in Alkanen, wie z.B. Pentan, Hexan, Heptan, Alkoholen, wie z.B. Ethanol, Isopropanol, und Diethylether dispergierbar ist. In Wasser ist der hydrophobisierte Zeolith dagegen nicht mehr dispergierbar.

### b) Beschichtung von Zeolith LTA mit Phenyltrimethoxysilan:

Es wurde wie in Beispiel 1a) verfahren, außer, dass Phenyltrimethoxysilan an Stelle von Isobutyltriethoxysilan verwendet wurde. Es wurde ein weißes, stark hydrophobes Pulver erhalten, welches sehr gut in o-Xylol, p-Xylol, Toluol und Benzol dispergierbar ist, nicht jedoch in Wasser.

### c) Beschichtung von Zeolith F mit Isobutyltriethoxysilan:

Es wurde wie in Beispiel 1a) verfahren, außer, dass an Stelle von 100 ml wässriger 20%ger Suspension des Zeoliths LTA 100 ml einer wässrigen 20%igen Suspension von Zeolith F mit einer mittleren Partikelgröße von 400 nm verwendet wurde. Es wurde ein weißes, stark hydrophobes Pulver erhalten, welches sehr gut in Alkanen, wie z.B. Pentan, Hexan, Heptan, Alkoholen, wie z.B. Ethanol, Isopropanol, und Diethylether dispergierbar ist. In Wasser ist der hydrophobisierte Zeolith dagegen nicht mehr dispergierbar.

### Vergleichsbeispiel 1

Als ein Vergleichsbeispiel wurde ein Zeolith LTA mit einer Partikelgröße von etwa 5 µm (Bestimmung über DLS) entsprechend dem bei Beispiel 1 beschriebenen Verfahren getrocknet und hydrophobisiert.

### Beispiel 2 - Überprüfung der Wasseraufnahmefähigkeit

10 g des entwässerten und hydrophobisierten Zeoliths aus Beispiel 1a) werden in einem Extruder in 90 g Polyethylen (Fp: etwa 125°C) eingebracht. Eine Wasseraufnahme des erhaltenen Polymerkomposits wird über die Massenzunahme bei Lagerung an Raumluft bestätigt. So wird innerhalb einer Woche bei einer relativen Luftfeuchtigkeit von etwa 40% und einer Temperatur von etwa 20°C eine Gewichtszunahme von 1,3 g bestimmt.

### Beispiel 3 - Herstellung Kompositmaterial

In 8 g eines UV-härtenden Klebers auf N,N-Dimethylacrylamid-Basis ("Locktite 3301", erhältlich von der Henkel Loctide Deutschland GmbH) werden 2 g des beschichteten Zeolithmaterials gemäß Beispiel 1a) eingerührt. Die entstandene Suspension wird fünf Minuten in ein Ultraschallbad getaucht. Das Klebstoffkomposit kann mit UV-Licht ausgehärtet werden und zum Abdecken feuchtigkeitsempfindlicher Substanzen verwendet werden.

### Beispiel 4 - Barriereeigenschaft Kompositmaterial

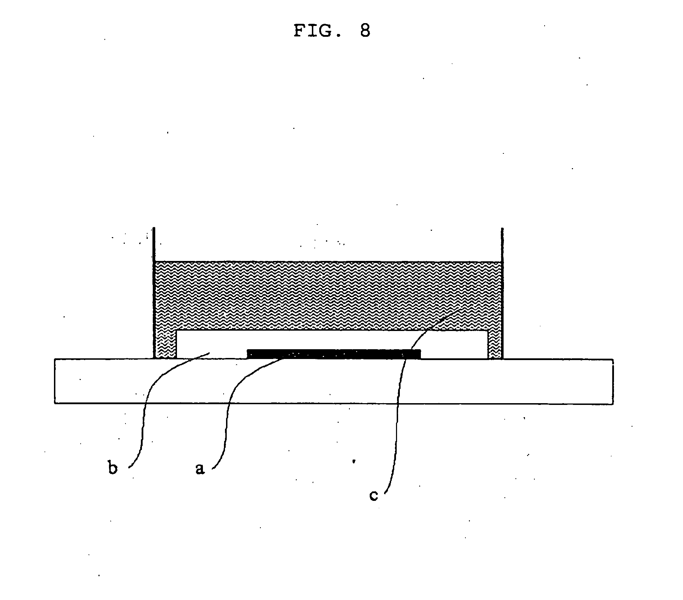

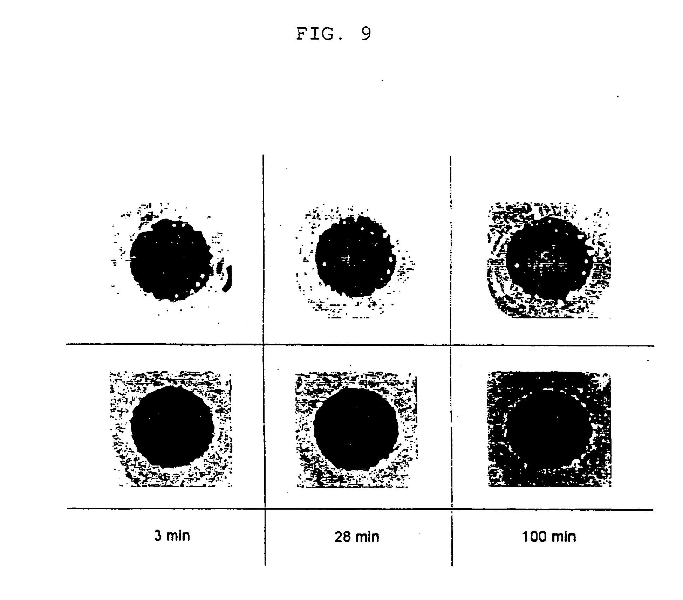

Zum Test der Fähigkeit zum Schutz von feuchtigkeitsempfindlicher Substanzen (Barriereeigenschaft) wurde der in Figur 8 gezeigte Versuchsaufbau verwendet. Unter Ausschluss von Feuchtigkeit werden jeweils mit 5 mg wasserfreiem, blauen Cobaltchlorid als Indikatorsubstanz getränkte Papierstücke mit einer Größe/Durchmesser von 15 mm auf je eine Glasplatte mit einer Fläche von 20 cm² aufgebracht. Dann wird eine der Glasplatten mit der in Beispiel 3 hergestellten Klebstoffzusammensetzung so übergossen, dass ein zusätzlicher Rand der Glasplatte von 8 mm um das mit der Indikatorsubstanz getränkte Papierstück von der Klebstoffzusammensetzung bedeckt wird, und die Klebstoffzusammensetzung wird mit UV-Licht ausgehärtet. In gleicher Weise, aber unter Verwendung eine reinen Klebstoffzusammensetzung ("Loctite 3301", erhältlich von der Henkel Loctide Deutschland GmbH), wird eine Referenzprobe hergestellt. Beide Proben werden mit Wasser bedeckt und die Veränderungen visuell beobachtet. Fotographien des Versuchablaufs werden in Figur 9 gezeigt. Ein Durchdringen von Wasser durch die Lackschicht zeigt sich durch ein Umschlagen der Farbe des Indikators Cobaltchlorid von Blau (dunkelgrau in Figur 9) nach Rosa (hellgrau in Figur 9). Wie aus Figur 9 deutlich zu erkennen ist, wird bei der Referenzprobe ein Durchdringen von Wasser schon nach 28 Minuten beobachtet, und nach 100 Minuten ist fast der gesamte Indikator rosa (hellgrau in Figur 9) gefärbt, d.h. mit Wasser in Berührung gekommen. Dahingegen zeigt die Probe gemäß der vorliegenden Erfindung während dieser Versuchszeit keinerlei Veränderung, d.h. der Indikator bleibt blau (dunkelgrau in Figur 9). Dieser Versuch zeigt, dass die Feuchtigkeitsaufnahme eines Wasserindikators (Cobaltchlorid) durch die Klebstoffzusammensetzung gemäß Beispiel 3 der vorliegenden Erfindung im Vergleich mit unbehandeltem Klebstoff stark verlangsamt wird.

### Beispiel 5 (nicht erfindungsgemäß)

1 g Zeolith LTL mit einer Partikelgröße von durchschnittlich 150 nm werden mit 50 ml konzentrierter CsCl-Lösung für eine Stunde lang bei Raumtemperatur gerührt, abfiltriert, gewaschen, in Wasser redispergiert und gefriergetrocknet. Nach einer Trocknung bei Raumtemperatur im Feinvakkuum wird der Zeolith mit 50 ml Toluol und 5 ml Isobutyldiethylethoxysilan unter Rückfluss für eine Stunde gekocht. Nach dem Abkühlen wird abfiltriert und mit Aceton gewaschen.

Das so dargestellt Material wird in 10 g Polyethylen (Fp: etwa 125°C) mit einem Miniaturextruder bei einer Temperatur von 120 eingebracht. Die optischen Eigenschaften des Kompositmaterials sind mit dem Auge nicht von dem des eingesetzten Polyethylens zu unterscheiden.

### Beispiel 6 - Calciumspiegeltest von Lacken

Zur Untersuchung der Eigenschaften von Lacken durch einen Calciumspiegeltest wurden die folgenden Proben und Vergleichsproben hergestellt:
Probe A) Reiner Lack (in Toluol gelöstes Polymer); Für seine Herstellung wurden 20 g TOPAS 8007 Granulat (erhältlich von der Firma Ticona, Kelsterbach) in 100 g trockenem Toluol gelöst.
Probe B) Lack wie in Probe A), versetzt mit 10 Gew.-% Zeolith LTA mit einer Partikelgröße von 300 nm.
Probe C) Lack wie in Probe B), jedoch versetzt mit 10 Gew.-% beschichtetem Zeolith LTA mit einer Partikelgröße von 300 nm gemäß Beispiel 1a).
Probe D) Lack wie in Probe B), jedoch versetzt mit 10 Gew.-% beschichtetem Zeolith LTA mit einer Partikelgröße von 5 µm.

Vier Objektträger aus Glas wurden im Vakuumverfahren mit Calcium bedampft. Die bedampften Objektträger wurden unter Ausschluss von Feuchtigkeit im Tauchverfahren mit jeweils einem der Lacke aus den Proben A) bis D) überzogen, wobei die Ziehgeschwindigkeit konstant 2 cm/s betrug. Die mit den Lacken der Proben A) bis D) überzogenen Objektträger wurden zwei Tage lang bei Raumtemperatur in inerter Atmosphäre (Argon, 99,999%) getrocknet.

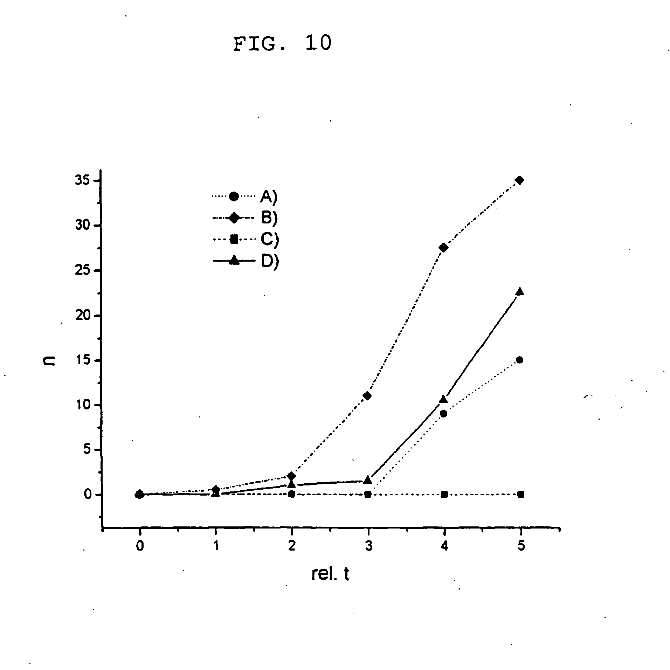

Dann wurde der Lack auf jeweils einer Seite der beschichteten und getrockneten Objektträger mit einem Messer abgekratzt. Die Rückseiten der Objektträger, die zum Zeitpunkt 0 jeweils einen vollständigen Spiegel zeigten, wurden über mehrere Tage in der Umgebungsatmosphäre (Luft) gelagert und vergleichend beobachtet. Bei den Objektträgern B) und D) wurden schnell punktuelle Trübungen des Spiegels beobachtet, während bei Objektträger A) nach einiger Zeit eine gehäufte Anzahl kleiner Trübungen beobachtet wurde. Objektträger C) zeigt am längsten keine Verschlechterung des Spiegels. Die erhaltenen Daten sind in Figur 10 dargestellt.

Zum Ausgleich der Variation der Luftfeuchtigkeit der Atmosphäre wurden die Daten gegen eine relative Zeitachse aufgetragen. Die Ergebnisse sind in Tabelle 1 zusammengestellt, wobei als Lebensdauer des Calciumspiegels der Zeitpunkt angegeben ist, bei dem es zu keiner sichtbaren Trübung kommt. Das Experiment zeigt, dass der Zusatz von beschichteten Zeolith gemäß der Erfindung zu einer längeren Lebensdauer des Calciumspiegels führt (Probe C). Der Zusatz von nicht beschichtetem Zeolith gleicher Größe (Probe B), als auch der Einsatz von beschichtetem Zeolith mit einer größeren Partikelgröße von etwa 5 Mikrometern (Probe D) führen zu einer Verkürzten Lebensdauer. Auffallend ist, dass die Zugabe von unbeschichteten Zeolithpartikeln mit einer Partikelgröße von 300 nm (Probe B) und die Zugabe von größeren beschichteten Zeolithpartikeln (Probe D) beide zu einer Verschlechterung der Barriereeigenschaft des verwendeten Lackes führen. Daher ist die signifikante Verbesserung der Barriereeigenschaft durch den erfindungsgemäßen Zeolithen umso überraschender.

**Tabelle 1**

| Probe | Zeolith | Beschichtung | Partikelgröße Zeolith [µm] | relative Lebensdauer |
|---|---|---|---|---|
| A | - | - | - | 3 |
| B | LTA | Nein | 300 | 1 |
| C | LTA | Ja | 300 | >5 |
| D | LTA | Ja | 5000 | 1 |

### Beispiel 7 - Transparente Folien

Zur Untersuchung der Eigenschaften von Folien wurden die folgenden Proben und Referenzproben hergestellt:
Probe E) 1000 g Polyethylen-Granulat (Fp: etwa 116°C) mit einer Korngröße von etwa 400 µm wurden mit einem Doppelschneckenextruder mit einer Breitschlitzdüse zu einem Band von etwa 30 mm Breite und 1 mm Dicke verarbeitet. Aus dem extrudierten Material wurden auf einer Heizpresse bei 200°C Folien mit einer Dicke von 100 µm hergestellt.
Probe F) 900 g Polyethylen-Granulat mit einer Korngröße von etwa 400 µm wurden mit 100 g Zeolith LTA mit einer mittleren Partikelgröße von 300 nm versetzt. Das erhaltene Gemisch wurde 200°C mit einem Doppelschneckenextruder mit einer Runddüse zu einem Polymerstrang von etwa 2 mm Durchmesser verarbeitet. Der Polymerstrang wurde nach dem Abkühlen zu Granulat zerkleinert. Das erhaltene Granulat wurde in der gleichen Weise wie bei Probe A) beschrieben zu Folien verarbeitet.
Probe G) Folien wurden in der gleichen Weise wie bei Probe F) beschrieben hergestellt, außer dass anstelle von 100 g Zeolith LTA 100 g beschichteter Zeolith LTA mit einer Partikelgröße von 300 nm, der in Beispiel 1a) hergestellt wurde, eingesetzt wurde.
Probe H) Folien wurden in der gleichen Weise wie bei Probe F) beschrieben hergestellt, außer dass anstelle von 100 g Zeolith LTA 100 g beschichteter Zeolith LTA mit einer Partikelgröße von etwa 5000 nm (etwa 5 µm), der in gleicher Weise wie in Beispiel 1 beschrieben hergestellt wurde, eingesetzt wurde.

Die so hergestellten Folienproben E) - H) wurden sowohl einer visuellen, als auch einer taktilen Prüfung unterzogen. Die Ergebnisse sind in Tabelle 2 zusammengefasst.

**Tabelle 2**

| Probe | Partikelgröße Zeolith [µm] | Beschichtung | Transparenz der Folie | Rauhigkeit der Folie |
|---|---|---|---|---|
| E | - | - | Transparent | Glatt |
| F | 300 | Nein | Trüb | Rauh |
| G | 300 | Ja | fast transparent | Glatt |
| H | 5000 | Ja | Trüb | Glatt |

Probe E), die keinen Zeolith umfasst, dient als Referenz für die Eigenschaften einer üblichen Folie, wie z.B. Transparenz und Rauhigkeit. Die Folie E) ist bei Durchsicht vollständig transparent und fühlt sich glatt an. Das Vergleichsbeispiel Probe F) enthält NanoZeolith LTA mit einer Partikelgröße von 300 nm. Allerdings ist der Zeolith nicht beschichtet und lässt sich deswegen nur schlecht in dem apolaren Polymer dispergieren. Es kommt zu einer Agglomeratbildung. Die Agglomerate führen zu einer spürbar rauhen Folie. An einigen Stellen sind die Agglomerate mit dem bloßen Auge sichtbar. Folie G) enthält mit Isobutylresten beschichteten Zeolith LTA mit einer Partikelgröße von 300 nm gemäß der Erfindung. Die Folie ähnelt der Referenzfolie E) stark. Sie ist ebenso glatt und in ihrer Transparenz kaum von ihr zu unterscheiden. Folie H) enthält beschichteten Zeolith LTA, allerdings mit einer Partikelgröße von etwa 5 Mikrometern. Folie H) macht zwar einen glatten Eindruck, ist aber wesentlich trüber als Folie E) und Folie G).

## Patentansprüche

1. Hydrophob beschichtetes Molekularsieb mit Partikeln einer Partikelgröße von 1000 nm oder weniger, wobei die Oberfläche der Partikel mit einem Silan der allgemeinen Formel
SiR¹R²R³R⁴
beschichtet wird, wobei zwei, oder drei der Reste R¹, R², R³ oder R⁴ des Silans unabhängig voneinander ein hydrolysierbarer Alkoxyrest sind, und wobei die restlichen Reste R¹, R², R³ und R⁴ unabhängig voneinander ausgewählt werden aus nicht-hydrolysierbaren unsubstituierten Alkylresten, Alkenylresten, Alkinylresten, Cycloalkylresten, Alkylcycloalkylresten, Arylresten, und Arylalkylresten, wobei die Partikel anorganische Partikel umfassen, die ausgewählt werden aus Partikeln, die poröse Alumophosphate, poröse Silicoalumophosphate oder Zeolithe umfassen, und wobei in jedem der oben angeführten Reste jeweils ein oder mehrere Wasserstoffatome durch Halogenatome ersetzt werden können.

2. Molekularsieb gemäß Anspruch 1, wobei jeder der hydrolysierbaren Reste des Silans unabhängig voneinander ein hydrolysierbarer Alkoxyrest ist, und die restlichen Reste nicht-hydrolysierbare Alkylreste sind.

3. Molekularsieb gemäß einem der vorherigen Ansprüche, wobei die Alkylreste verzweigte Alkylreste mit drei bis acht Kohlenstoffatomen sind.

4. Molekularsieb gemäß einem der vorherigen Ansprüche, wobei die Partikel ausgewählt werden aus Zeolith Na-P1 (GIS-Struktur), Zeolith F, oder Zeolith LTA, und das Silan einen Alkylrest und drei hydrolysierbare Alkoxyreste umfasst.

5. Verfahren zur Herstellung eines Molekularsiebs gemäß einem der Ansprüche 1 bis 4, wobei Partikel mit einer Partikelgröße von 1000 nm oder weniger mit mindestens einem Silan der allgemeinen Formel
SiR¹R²R³R⁴
zur Reaktion gebracht werden, wobei die Reste R¹-R⁴ und die Partikel wie in den Ansprüchen 1-4 definiert sind.

6. Verfahren gemäß Anspruch 5, wobei die Partikel vor Reaktion mit dem Silan getrocknet werden.

7. Verfahren gemäß Anspruch 6, wobei die Partikel durch ein Verfahren getrocknet werden, das ausgewählt wird aus Ausheizen im Vakuum und Gefriertrocknen.

8. Molekularsieb, erhältlich durch ein Verfahren gemäß einem der Ansprüche 5 bis 7.

9. Zusammensetzung, umfassend das Molekularsieb gemäß einem der Ansprüche 1 bis 4 oder 8 und eine organische Verbindung.

10. Zusammensetzung gemäß Anspruch 9, wobei die organische Verbindung eine polymere Verbindung umfasst.

11. Zusammensetzung gemäß Anspruch 10, wobei die polymere Verbindung thermoplastisch ist.

12. Zusammensetzung gemäß einem der Ansprüche 9 bis 11, wobei die polymere Verbindung eine Wasserpermeabilität von unter 0,9 g·mm/m²·d bei einem Gefälle von 0% zu 90% relativer Luftfeuchtigkeit besitzt.

13. Vorrichtung, umfassend ein Molekularsieb oder eine Zusammensetzung gemäß einem der Ansprüche 1 bis 4 oder 8 bis 12.

14. Vorrichtung gemäß Anspruch 13, **dadurch gekennzeichnet, dass** sie mit einer Zusammensetzung gemäß einem der Ansprüche 9 bis 12 hergestellt oder versiegelt wurde.

15. Vorrichtung gemäß Anspruch 13 oder 14, **dadurch gekennzeichnet, dass** sie eine Verpackung ist.

16. Vorrichtung gemäß 13 oder 14, **dadurch gekennzeichnet, dass** sie ein elektronisches Bauteil ist.

17. Vorrichtung gemäß Anspruch 16, wobei das elektronische Bauteil ausgewählt wird aus einem MEMS und einer OLED.

18. Vorrichtung gemäß einem der Ansprüche 13 bis 17, wobei eine zu schützende Oberfläche direkt mit der Zusammensetzung beschichtet wird.

19. Vorrichtung gemäß Anspruch 18, wobei die Zusammensetzung durch eine Druckdüse auf die zu beschichtende Oberfläche aufgedruckt wird.

20. Vorrichtung gemäß einem der Ansprüche 13, 14, 15, 18 oder 19, **dadurch gekennzeichnet, dass** sie eine Membran ist.

21. Verwendung des Molekularsiebs oder der Zusammensetzung gemäß einem der Ansprüche 1 bis 4 oder 8 bis 12 als Gettermaterial.

## Claims

1. Hydrophobically coated molecular sieve comprising particles of a particle size of 1000 nm or less, the surface of the particles being coated with a silane of the general formula
SiR¹R²R³R⁴,
two or three of the radicals R¹, R², R³ or R⁴ being, independently of the others, a hydrolysable alkoxy radical, and the remaining radicals R¹, R², R³ and R⁴ being, independently of the others, selected from non-hydrolysable unsubstituted alkyl residues, alkenyl residues, alkynyl residues, cycloalkyl residues, alkylcycloalkyl residues, aryl residues, and arylalkyl residues, the particles comprising inorganic particles selected from particles which comprise porous aluminophosphates, porous silicoaluminophosphates or zeolites, and wherein, in each of the residues listed above, any one or more of the hydrogen atoms may be substituted by halogen atoms.

2. Molecular sieve according to claim 1, wherein each of the hydrolysable radicals of the silane is, independently of the others, a hydrolysable alkoxy radical, and the remaining radicals are non-hydrolysable alkyl radicals.

3. Molecular sieve according to one of the preceding claims, wherein the alkyl radicals are branched alkyl radicals having from three to eight carbon atoms.

4. Molecular sieve according to one of the preceding claims, wherein the particles are selected from zeolite Na-P1 (GIS structure), zeolite F and zeolite LTA, and the silane contains one alkyl radical and three hydrolysable alkoxy radicals.

5. Method of producing a molecular sieve according to one of claims 1 to 4, wherein particles having a particle size of 1000 nm or less are made to react with at least one silane of the general formula
SiR¹R²R³R⁴,
the radicals R¹ - R⁴ and the particles being as defined in claims 1 - 4.

6. Method according to claim 5, wherein the particles are dried before reaction with the silane.

7. Method according to claim 6, wherein the particles are dried by means of a method selected from heating in a vacuum and freeze-drying.

8. Molecular sieve obtainable by a method according to one of claims 5 to 7.

9. Composition comprising the molecular sieve according to one of claims 1 to 4 or 8 and an organic compound.

10. Composition according to claim 9, wherein the organic compound comprises a polymeric compound.

11. Composition according to claim 10, wherein the polymeric compound is thermoplastic.

12. Composition according to one of claims 9 to 11, wherein the polymeric compound has a water permeability of less than 0.9 g·mm/m²·d at a gradient of from 0% to 90% relative atmospheric humidity.

13. Apparatus comprising a molecular sieve or a composition according to one of claims 1 to 4 or 8 to 12.

14. Apparatus according to claim 13, **characterised in that** it has been produced or sealed using a composition according to one of claims 9 to 12.

15. Apparatus according to claim 13 or 14, **characterised in that** it is a packaging.

16. Apparatus according to claim 13 or 14, **characterised in that** it is an electronic component.

17. Apparatus according to claim 16, wherein the electronic component is selected from a MEMS and an OLED.

18. Apparatus according to one of claims 13 to 17, wherein a surface to be protected is coated directly with the composition.

19. Apparatus according to claim 18, wherein the composition is printed through a printing nozzle onto the surface to be coated.

20. Apparatus according to one of claims 13, 14, 15, 18 or 19, **characterised in that** it is a membrane.

21. Use of the molecular sieve or composition according to one of claims 1 to 4 or 8 to 12 as getter material.

## Revendications

1. Tamis moléculaire revêtu hydrophobe avec des particules d'une taille de particules de 1000 nm ou moins, la surface des particules étant revêtue de silane de formule générale
SiR¹R²R³R⁴
dans laquelle deux ou trois des résidus R¹, R², R³ ou R⁴ du silane sont indépendamment les uns des autres un résidu alkoxy hydrolysable et dans laquelle les autres résidus R¹, R², R³ et R⁴ sont choisis indépendamment les uns des autres parmi des résidus alkyle, des résidus alcényle, des résidus alkinyles, des résidus cycloalkyle, des résidus alkylcycloalkyle, des résidus aryle et des résidus arylalkyle non hydrolysables non substitués, dans lequel les particules comprennent des particules anorganiques qui sont choisies parmi des particules qui comprennent des aluminophosphates poreux, des silicoaluminophosphates poreux ou des zéolithes et dans lequel, dans chacun des résidus ci-dessus, un ou plusieurs atomes d'hydrogène peuvent être remplacés par un atome halogène.

2. Tamis moléculaire selon la revendication 1, dans lequel chacun des résidus hydrolysables du silane est un résidu alkoxy hydrolysable indépendamment des autres et les autres résidus sont des résidus alkyle non hydrolysables.

3. Tamis moléculaire selon l'une des revendications précédentes, dans lequel les résidus alkyle sont des résidus alkyle ramifiés avec trois à huit atomes de carbone.

4. Tamis moléculaire selon l'une des revendications précédentes, dans lequel les particules sont choisies parmi la zéolithe Na-P1 (structure GIS), la zéolithe F ou la zéolithe LTA, et le silane comprend un résidu alkyle et trois résidus alkoxy hydrolysables.

5. Procédé pour la production d'un tamis moléculaire selon l'une des revendications 1 à 4, dans lequel des particules d'une taille de particules de 1000 nm ou moins sont mises en réaction avec un silane de formule générale
SiR¹R²R³R⁴
les résidus R¹-R⁴ et les particules étant définis comme dans les revendications 1-4.

6. Procédé selon la revendication 5, dans lequel les particules sont séchées avant la réaction avec le silane.

7. Procédé selon la revendication 6, dans lequel les particules sont séchées par un procédé qui est choisi parmi l'étuvage sous vide et la lyophilisation.

8. Tamis moléculaire obtenu par un procédé selon l'une des revendications 5 à 7.

9. Composition comprenant le tamis moléculaire selon l'une des revendications 1 à 4 ou 8 et un composé organique.

10. Composition selon la revendication 9, dans laquelle le composé organique comprend un composé polymère.

11. Composition selon la revendication 10, dans laquelle le composé polymère est thermoplastique.

12. Composition selon l'une des revendications 9 à 11, dans laquelle le composé polymère présente une perméabilité à l'eau de moins de 0,9 g/mm/m².d à une humidité relative de l'air de 0 à 90 %.

13. Dispositif comprenant un tamis moléculaire ou une composition selon l'une des revendications 1 à 4 ou 8 à 12.

14. Dispositif selon la revendication 13, **caractérisé en ce qu'**il est fabriqué ou scellé avec une composition selon l'une des revendications 9 à 12.

15. Dispositif selon la revendication 13 ou 14, **caractérisé en ce qu'**il s'agit d'un emballage.

16. Dispositif selon la revendication 13 ou 14, **caractérisé en ce qu'**il s'agit d'un composant électronique.

17. Dispositif selon la revendication 16, dans lequel le composant électronique est choisi parmi un nanosystème électromécanique ou une DELO.

18. Dispositif selon l'une des revendications 13 à 17, dans lequel une surface à protéger est directement recouverte de la composition.

19. Dispositif selon la revendication 18, dans lequel la composition est appliquée sur la surface à recouvrir avec une buse de projection.

20. Dispositif selon l'une des revendications 13, 14, 15, 18 ou 19, **caractérisé en ce qu'**il s'agit d'une membrane.

21. Utilisation du tamis moléculaire ou de la composition selon l'une des revendications 1 à 4 ou 8 à 12 comme getter.
